(19) Europäisches Patentamt
European Patent Office
Office européen des brevets

(11) **EP 2 606 288 B1**

(12) **EUROPÄISCHE PATENTSCHRIFT**

(45) Veröffentlichungstag und Bekanntmachung des Hinweises auf die Patenterteilung:
**10.09.2014 Patentblatt 2014/37**

(21) Anmeldenummer: **11748258.8**

(22) Anmeldetag: **22.07.2011**

(51) Int Cl.:
*F24J 2/07* *(2006.01)*   *F24J 2/16* *(2006.01)*
*F24J 2/10* *(2006.01)*   *F24J 2/54* *(2006.01)*

(86) Internationale Anmeldenummer:
**PCT/EP2011/003690**

(87) Internationale Veröffentlichungsnummer:
**WO 2012/022418 (23.02.2012 Gazette 2012/08)**

(54) **SOLARES ZENTRALRECEIVERSYSTEM MIT EINEM HELIOSTATENFELD UND VERFAHREN ZUR ERSTELLUNG EINES HELOSTATENFELDES EINES SOLCHEN SYSTEMS**

CENTRAL RECEIVER SOLAR SYSTEM COMPRISING A HELIOSTAT FIELD AND PROCESS TO INSTALL A FIELD OF HELIOSTATS OF SUCH A SYSTEM

SYSTÈME DE RÉCEPTEUR CENTRAL SOLAIRE COMPORTANT UN CHAMP D'HÉLIOSTATS ET PRCEDURE D'UNE INSTALLATION D'UN CHAMPS DE HÉLIOSTATS D'UN TEL SYSTÈME

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.08.2010 DE 102010034986**

(43) Veröffentlichungstag der Anmeldung:
**26.06.2013 Patentblatt 2013/26**

(73) Patentinhaber: **Schramek, Philipp**
**82319 Starnberg (DE)**

(72) Erfinder: **MAASS, Joachim**
**82319 Starnberg (DE)**

(74) Vertreter: **Fritzsche, Thomas**
**Fritzsche Patent**
**Naupliastraße 110**
**81545 München (DE)**

(56) Entgegenhaltungen:
**EP-A2- 0 909 929      EP-A2- 2 000 669**
**WO-A1-02/070966      WO-A1-2008/092194**
**WO-A1-2008/154521      WO-A1-2010/050467**
**WO-A2-2009/021099      DE-A1-102006 053 758**
**FR-A1- 2 292 200      US-A- 4 044 753**
**US-A- 4 117 682      US-A- 4 172 443**
**US-A1- 2004 004 175**

**Beschreibung**

Die Erfindung betrifft Verfahren zur Auslegung eines Heliostatenfeldes eines solares Zentralreceiversystems und ein solares Zentralreceiversystem mit einem Heliostatenfeld, bestehend aus einem oder mehreren Receivern, einer Vielzahl von das Heliostatenfeld bildenden Heliostaten, die auf einer vorzugsweise ebenen Gesamtgrundfläche angeordnet sind, wobei der Heliostat einen um zwei Drehachsen verstellbaren Reflektor aufweist, der die solare Strahlung auf die Zielfläche des einen oder der mehreren Receiver bei veränderndem Sonnenstand reflektiert, wobei die Zielfläche die Apertur, der thermische Absorber oder der photovoltaische Absorber des jeweiligen Receivers ist, wobei der Heliostat eine erste Drehachse und eine zur ersten senkrechte zweite Drehachse hat, der auf einer Aufstellfläche angeordnet ist, wobei die erste Drehachse in Bezug auf die Aufstellfläche und die zweite Drehachse in Bezug auf den Reflektor fest angeordnet sind, und einer Tragestruktur, an der der eine oder die mehreren Receiver oberhalb in Bezug auf die Erdoberfläche des Heliostatenfeldes befestigt sind.

**Stand der Technik**

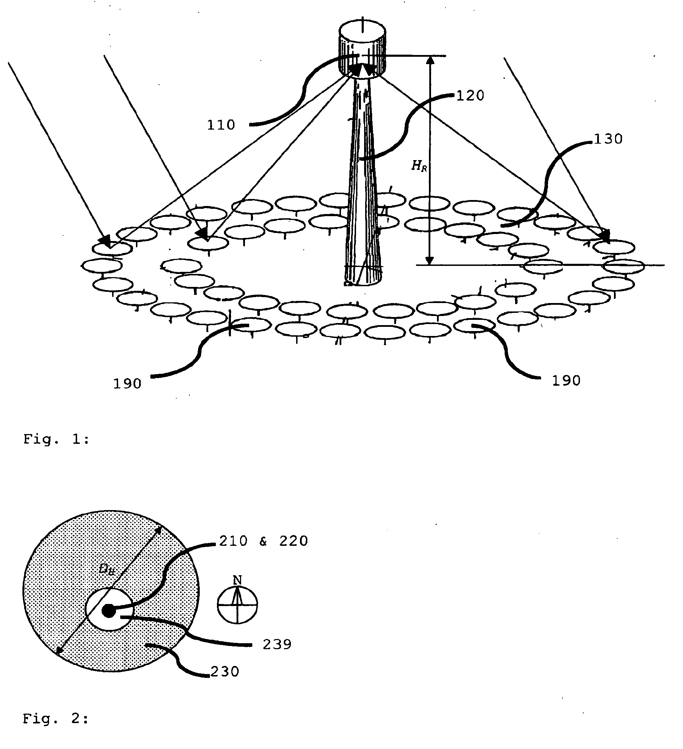

Im Folgenden wird die grundlegende Funktion bekannter Solarturmkraftwerke bzw. Solarturmsysteme an Hand der Fig. 1 bis Fig. 6 erläutert.

In Fig. 1 ist ein aus US 4 172 443 bekanntes Solarturmkraftwerk bzw. Solarturmsystem dargestellt, das einen Turm 120 aufweist, auf dem ein Receiver 110 installiert ist, auf den Heliostaten 190 solare Strahlung konzentrieren. Das Heliostatenfeld 130 besteht aus einer Vielzahl solcher Heliostaten 190. Bei anderen bekannten Türmen können sogar mehrere Receiver auf einem Turm installiert sein, wie in EP 2000669 A2 gezeigt. Wie in [1] - insbesondere auf den Seiten 237ff - dargestellt, erhitzt die konzentrierte Strahlung durch den Receiver ein Wärmeträgermedium, durch das eine Turbine angetrieben wird, die dann über einen mechanisch gekoppelten Generator elektrischen Strom erzeugt.

Heute bekannte Solarturmsysteme können, wie folgt, in vier Solarturmsysteme klassifiziert und charakterisiert werden:

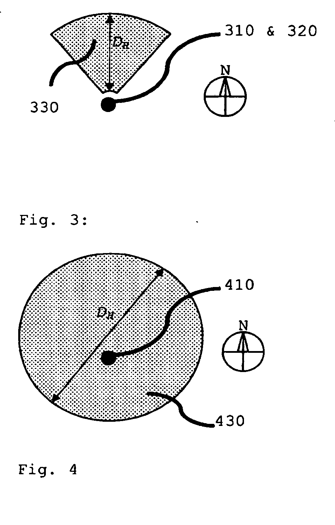

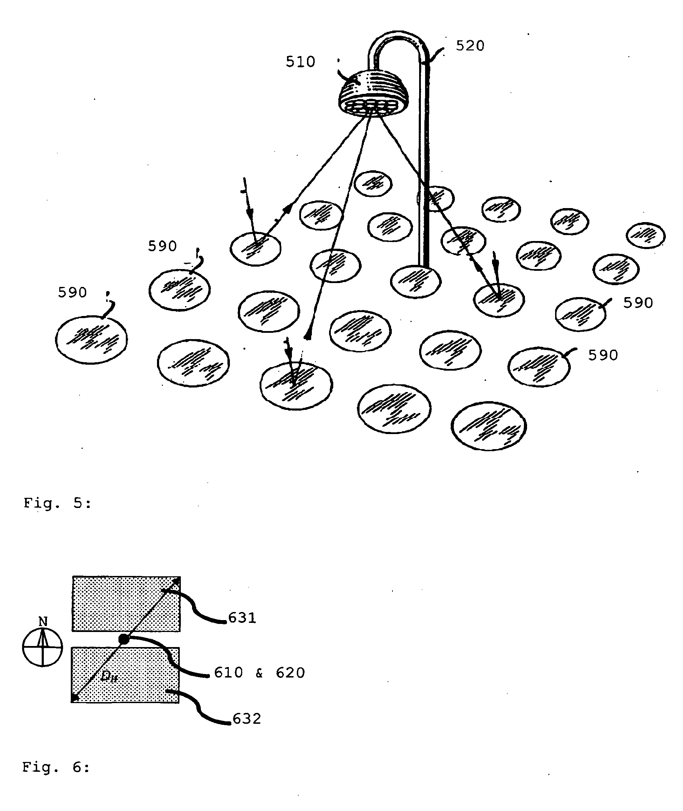

1. **Solarturmsystem mit umgebendem Heliostatenfeld (Fernfeld),** siehe Prinzipdarstellung einer Draufsicht in Fig. 2.
2. **Solarturmsystem mit Polarfeld,** siehe Prinzipdarstellung einer Draufsicht in Fig. 3.
3. **Solarturmsystem mit Heliostatenfeld unterhalb des Receivers (Nahfeld),** siehe Prinzipdarstellung einer Draufsicht in Fig. 4 und in perspektivischer Sicht in Fig. 5.
4. **Solarturmsystem mit Nord- und Südfeld,** siehe Prinzipdarstellung einer Draufsicht in Fig. 6.

Die erwähnten der Fig. 2 bis Fig. 6 werden nachstehend detaillierter beschrieben.

**1. Solarturmsysteme mit umgebenden Heliostatenfeld (Fernfeld)**

Die meisten (kommerziellen) Solarturmsysteme bestehen aus einem um 360° in alle Himmelsrichtungen orientierten zylindrischen oder auf dem Kopf stehenden kegelstumpfförmigen Receiver, der von einem zentralen Turm gehalten wird und der von einem aus einzelnen Heliostaten 190 gebildeten Heliostatenfeld 130 umgeben ist, wie in Fig. 1 und als Draufsicht in Fig. 2 dargestellt. Ein zylindrischer Receiver oder ein auf dem Kopf stehender kegelstumpfförmiger Receiver sind Receiver mit externem Absorber, bei dem die Mantelfläche des Receivers die Absorberfläche bildet. In Fig. 1 ist ein aus US 4 172 443 bekanntes Solarturmsystem dargestellt, bei der ein zylindrischer Receiver 110, dessen zylindrischer Außenmantel die Absorberfläche bildet, auf einem Turm 120 in einer Receiverhöhe $H_R$ oberhalb des Heliostatenfeldes 130 angeordnet ist.

Fig. 2 zeigt die Prinzipdarstellung einer Draufsicht auf ein bekanntes Solarturmsystem mit einem den Turm 210 im Abstand umgebenden Heliostatenfeld 230. Das Heliostatenfeld 230 hat die Form eines Ringes, bei dem die Region 234 in der Umgebung des den Receiver 210 tragenden Turmes 220 frei ist, d.h. dass in der Region 234 keine Heliostaten angeordnet sind. Die Position des Turmes mit dem Receiver liegt häufig nicht genau zentral, sondern ist im Hinblick auf das Heliostatenfeld in Richtung Äquator verschoben, d.h. auf der nördlichen Hemisphäre der Erde nach Süden bzw. auf der südlichen Hemisphäre der Erde nach Norden.

Bei Fig. 2 besteht das Heliostatenfeld aus einem Fernfeld. Das Fernfeld ist ein Heliostatenfeld - das in Abgrenzung zum weiter unten definierten Nahfeld - den Turm und den Receiver mit einem gewissen horizontalen Abstand umgibt, und dessen Reflektorflächendichte $\varrho$ mit dem größer werdenden Abstand vom Receiver abnimmt. Die Reflektorflächendichte $\varrho$ ist definiert als das Verhältnis der Reflektorfläche des Heliostatenfeldes zur Grundfläche des Heliostatenfeldes. In Fig. 2 ist die Region 234 nahe am Receiver 210, in der keine Heliostaten installiert sind, dargestellt.

Der Receiver kann, statt kontinuierlich zylindrisch oder kontinuierlich kegelstumpfförmig zu sein, u.a. auch aus einer Mehrzahl von Einzel-Receivern bestehen.

Die Receiverhöhe $H_R$ ist, wie in Fig. 1 gezeigt, definiert als vertikaler Abstand des Mittelpunktes der Absorberfläche eines Receivers mit externem Absorber oder der Receiver-Apertur eines Hohlraumreceivers von der Ebene, die durch die Mittelpunkte der Reflektoren der Heliostaten des Heliostatenfeldes definiert ist. Die Receiverhöhe $H_R$ wird im Folgenden als eine Einheitsgröße verwendet, an der andere Größen, wie z.B. die Heliostatenfeld-Größe, bemessen werden.

Der Durchmesser $D_H$ eines Heliostatenfeldes wird, wie in den Fig. 2, 3, 4 und 6 gezeigt, definiert als der Abstand, der am weitesten voneinander entfernten Heliostaten.

Solarturmsysteme mit umgebendem Heliostatenfeld haben typischerweise Receiverhöhen $H_R$ von über 100 m und Heliostatenfelder mit einem Durchmesser von mehr als acht Receiverhöhen, d.h. $D_H > 8 \times H_R$. Beispielsweise hat der in [2] beschriebene Gemasolar Solarturm eine Receiverhöhe $H_R$ von 140 m und einen Durchmesser $D_H$ von ca. 1.200 m. Beispielsweise hat der in [3] beschriebene Solarturm von Solar-Reserve eine Receiverhöhe $H_R$ = 182,88 m (600 feet) und $D_H$ = 2600 m.

## 2. Solarturmsysteme mit Polarfeld

Wie in der in der Prinzipdarstellung der Draufsicht auf ein Solarturmsystem mit Polarfeld in Fig. 3 zu sehen, hat dies ein Heliostatenfeld 330 nur auf der polaren Seite - zeigt in Richtung Norden auf der nördlichen Hemisphäre der Erde und in Richtung Süden auf der südlichen Hemisphäre - des Turmes 320 und Receiver 310 und, wie in EP 2000669 A2 gezeigt, mit einem oder mehreren zum Heliostatenfeld ausgerichteten Receivern 310 auf dem Turm 320.

So wie das Fernfeld eines Solarturms mit umgebendem Heliostatenfeld, nimmt die Reflektorflächendichte $\varrho$ des Polarfeldes mit zunehmendem Abstand vom Receiver zu.

Solarturmsysteme mit Polarfeld haben typischerweise Receiverhöhen von 50 - 150 m und Heliostatenfelder mit einem Durchmesser $D_H$ von ca. fünf bis sechs Receiverhöhen, wobei gilt $3 \times H_R < D_H < 7 \times H_R$.

Beispielsweise hat der in [4] beschriebene "Solarturm Jülich" eine Receiverhöhe $H_R$ von 55 m und einen Durchmesser $D_H$ des Heliostatenfeldes von ca. 300 m.

Beispielsweise hat der in [5] beschriebene "PS10-Solarturm" eine Receiverhöhe $H_R$ = 115 m und einen Durchmesser $D_H$ = 750 m, der "PS20-Solarturm" hat $H_R$ = 165 m und $D_H$ = 1000 m.

## 3. Solarturmsystem mit Heliostatenfeld unterhalb des Receivers (Nahfeld)

In den 1960ern wurde von Giovanni Francia in Italien ein erstes Solarturmsystem entwickelt, bei dem sich das Heliostatenfeld unterhalb des nach unten gerichteten Receivers befindet und sich in Nord-, Süd-, Ost- und West-Richtung erstreckt. Dies ist in Fig. 4 dargestellt, in der das Heliostatenfeld 430 und die Position des Receivers 410 in der Draufsicht zu sehen sind. Im Gegensatz zu dem oben erläuterten Fernfeld ist das Heliostatenfeld ein Nahfeld in dem die Heliostaten mit konstanter Reflektorflächendichte $\varrho$ aufgestellt sind. Der Receiver 510 ist an ein Auslegersystem 520 hängend montiert, wie in Fig. 5 gezeigt. Für weitere Ausführungen siehe Seite 238 in [1] und US 4220140. Aus Fig. 7.77 auf Seite 238 in [1] lässt sich ableiten, dass das Heliostatenfeld aus runden Heliostaten eine recht hohe Reflektorflächendichte $\varrho$ von ca. 60% hat, die mit rechteckigen Heliostaten nicht erreicht werden kann - siehe hierzu Seite 706 in [8]. Detailliertere veröffentlichte Daten der Reflektorflächendichte $\varrho$ des Solarturmsystems von Giovanni Francia sind nicht bekannt.

Die von Giovanni Francia entwickelten Solarturmsysteme mit Heliostatenfeld unterhalb des Receiver haben typischerweise Recei-verhöhen $H_R$ von weniger als 20 m und Heliostatenfelder mit einem Durchmesser $D_H$ von weniger als zwei Receiverhöhen $H_R$, d.h. $D_H < 2 \times H_R$, wie aus der Fig. 7.77 auf Seite 238 in [1] zu erkennen. Detailliertere veröffentlichte Daten sind nicht bekannt.

## 4. Solarturmsystem mit Nord- und Südfeld

Ein weiteres in [7] beschriebenes Solarturmsystem, welches von dem Unternehmen eSolar Inc., Homepage und Sitzadresse siehe [6], entwickelt wurde, ist eine Mischung aus einem Solarturmsystem mit umgebenden Heliostatenfeld und einem Solarturmsystem mit Polarfeld. Wie in der Draufsicht in Fig. 6 zu sehen, besteht es aus einem Turm 620, auf dem sich ein Receiver 610 mit zwei Aperturen befindet, und einem Nordfeld 631 und einem Südfeld 632, die zusammen den Turm 620 nahezu ganz umgeben, wie ein umgebendes Heliostatenfeld. In diesem Fall hat der einzelne Receiver 610 zwei Aperturen, eine ist zum Nordfeld und die andere zum Südfeld ausgerichtet, wie in [7] näher beschrieben.

Charakteristisch für dieses Heliostatenfeld des Solarturmsystems von eSolar Inc. ist die gleichmäßige Reflektorflächendichte $\varrho$ des gesamten Heliostatenfeldes. Siehe WO 2008/154521 A1. Das Heliostatenfeld von eSolar Inc. unterscheidet sich jedoch von dem So-larturmsystem mit Nahfeld von Giovanni Francia darin, dass das Heliostatenfeld sich nicht unterhalb des Receivers befindet und die Reflektorflächendichte $\varrho$ kleiner als 50% ist.

Solarturmsysteme mit Nord- und Südfeld von eSolar Inc. haben typischerweise Receiverhöhen $H_R$ von ca. 50 m und Heliostatenfelder mit einem Durchmesser $D_H$ von ca. fünf Receiverhöhen, d.h. es gilt $D_H = 5 \times H_R$, wie in [7] näher beschrieben.

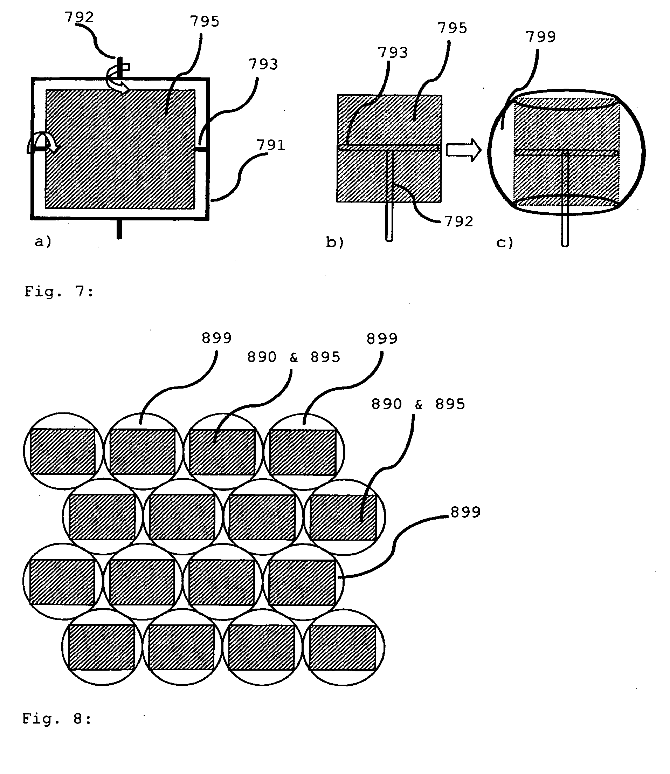

Weitere bekannte Technologien für Solarturmsystem sind die zumeist verwendeten Heliostaten mit fester Vertikalachsenaufhängung (FVA) und die bekannten aber zumeist nicht verwendeten Heliostaten mit fester Horizontalachsenaufhängung (FHA), die an Hand der Fig. 7 bis Fig. 10 erläutert werden.

**Heliostaten mit fester Horizontalachsen-Aufhängung (FHA)**

In WO 02/070966 A1, WO 2008/092194 A1, WO 2008/092195 A1 und [8] werden Heliostaten mit fester Horizontalachsen-Aufhängung (FHA) beschrieben. Heliostaten mit FHA unterscheiden sich von konventionellen Heliostaten, die eine feste Vertikalachsen-Aufhängung (FVA) haben, durch das Raumvolumen, in dem die Reflektoren sich aufgrund Ihrer Aufhängung frei bewegen können.

Ein Heliostat hat eine erste Drehachse und eine zur ersten senkrecht angeordnete zweite Drehachse und ist auf einer Aufstellfläche angeordnet, wobei die erste Drehachse in Bezug auf die Aufstellfläche und die zweite Drehachse in Bezug auf den Reflektor fest angeordnet sind.

In Fig. 7 sind die aus [8] bekannten Darstellungen des Prinzips eines Heliostaten mit FVA gezeigt. In Fig. 7a ist das Prinzip eines Heliostaten mit FVA dargestellt und in Fig. 7b ein beispielhafter rechteckiger Heliostat und in Fig. 7c das dazugehörige Raumvolumen, in dem sich der Reflektor des Heliostaten aufgrund der Aufhängung frei bewegen kann. Wie in Fig. 7a und Fig. 7b zu erkennen, ist bei einem Heliostaten mit FVA die erste mit der Aufstellfläche oder Grundfläche fest verbundene Drehachse 792 vertikal bzw. senkrecht zur Aufstellfläche oder Grundfläche, während die zweite Drehachse 793, senkrecht zur ersten, um die erste Drehachse 792 beweglich ist.

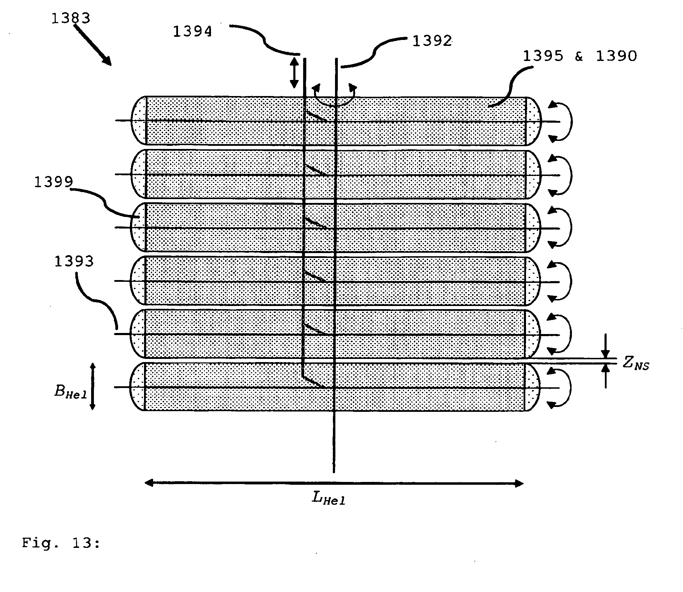

In Fig. 7c ist das Raumvolumen 799, in dem der Reflektor sich aufgrund der Aufhängungen frei bewegen kann, zu erkennen. Das Raumvolumen ist ein Tonnenkörper, der einer Schicht einer Kugel entspricht bei dem die Flächen sich oben und unten befinden, also senkrecht zur ersten mit der Aufstellfläche fest verbundenen vertikalen Drehachse 792. In Fig. 13 in WO 2008/092195 A1 und den zugehörigen Erläuterungen wird ein Heliostat mit FVA und dazugehörigem Raumvolumen, in dem sich der Reflektor des Heliostaten aufgrund der Aufhängung frei bewegen kann, dargestellt und erläutert.

In der aus [8] bekannten Fig. 8 ist dargestellt, mit welchen Abständen Heliostaten 890 mit FVA aufgestellt werden können, ohne dass die Raumvolumina 899, in denen die Reflektoren der Heliostaten 890 sich frei bewegen können, überlappen, um Kollision zwischen den Heliostaten zu vermeiden.

Die bekannten Hersteller von Heliostaten verwenden Heliostaten mit FVA.

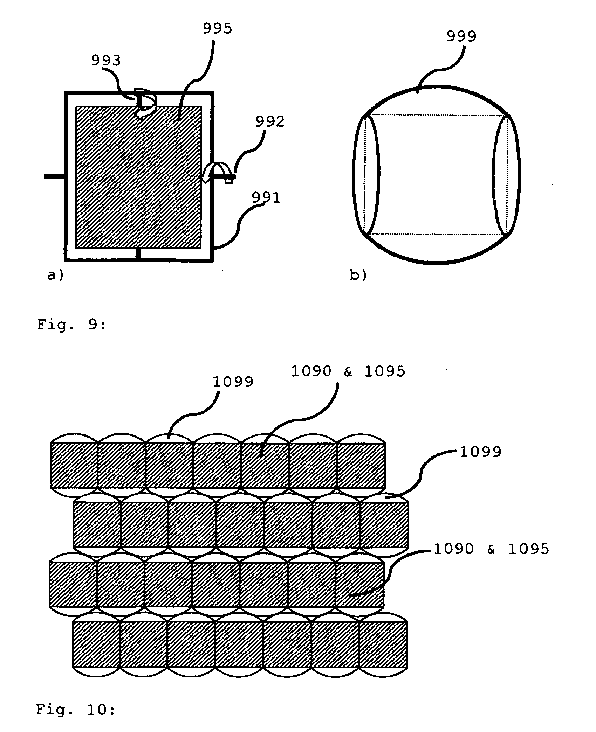

Bei einem Heliostaten mit FHA ist die erste mit der Aufstellfläche fest verbundene Drehachse 992 parallel zur Aufstellfläche oder Grundfläche, wie in der systematischen Darstellung in Fig. 9a zu sehen. Die erste feste horizontale Drehachse 992 ist beim Heliostaten mit FHA mit dem Boden fest verbunden, wie in WO 2008/092194 A1 und WO 2008/092195 A1 dargestellt, während sich die zweite Drehachse 993, senkrecht zur ersten, um die erste Drehachse 992 drehen kann.

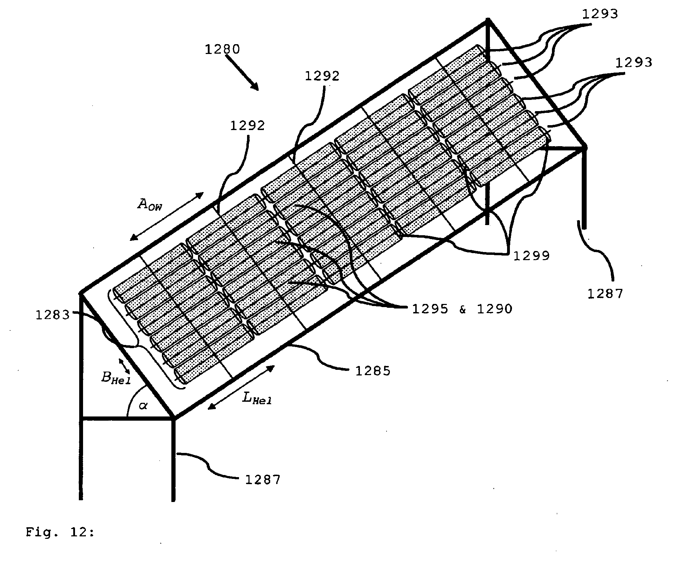

Wie in Fig. 9b zu sehen, ist das Raumvolumen 999, in dem sich der Reflektor eines Heliostaten mit FHA frei bewegen kann, gleich dem des Heliostaten mit FVA, allerdings um 90° gedreht, so dass die mit der zur Aufstellfläche parallel fest verbundene Drehachse 992 senkrecht zu den Flächen des Tonnenkörpers steht. In Fig. 12 in WO 2008/092195 A1 und den zugehörigen Erläuterungen wird ein Heliostat mit FHA und dazugehörigen Raumvolumen, in dem sich der Reflektor des Heliostaten aufgrund der Aufhängung frei bewegen kann, erläutert.

Wie in Fig. 10 zu sehen und aus [8] bekannt, können Heliostaten mit FHA in Reihen dicht aufgestellt werden, ohne dass die Raumvolumina 1099, in denen sich die Reflektoren benachbarter Heliostaten 1090 frei bewegen können, überlappen. In Fig. 10 ist die theoretisch maximale Reflektorflächendichte für die gegebene Reflektorgröße dargestellt, mit keiner Sicherheitstoleranz zwischen benachbarten Heliostaten. Außerdem sind die Reihen zueinander versetzt, um diese möglichst dicht aufzustellen.

Es ist zu erkennen, dass Heliostaten mit FHA höhere Reflektorflächendichten ermöglichen als Heliostaten mit FVA. Wie in Fig. 10 in [8] dargestellt und den dazugehörigen Erläuterungen hergeleitet, ist die maximal mögliche Reflektorflächendichte von rechteckigen Heliostaten mit FVA im idealen Fall ca. 58%, während rechteckige Heliostaten mit FHA wesentlich höhere Reflektorflächendichten ermöglichen, mit theoretisch bis nahezu 100%. Wie aus [8] bekannt, erhöht sich die die theoretisch mögliche maximale Reflektorflächendichte $\rho$ eines Heliostatenfeldes, wenn jeder Reflektor 995 in Richtung der zweiten Drehachse 993 länger ist, als in die dazu senkrechte Richtung.

In Fig. 6 in WO 02/070966 A1 und den dazugehörigen Erläuterungen ist die mechanische Koppelung von Heliostaten mit FHA dargestellt.

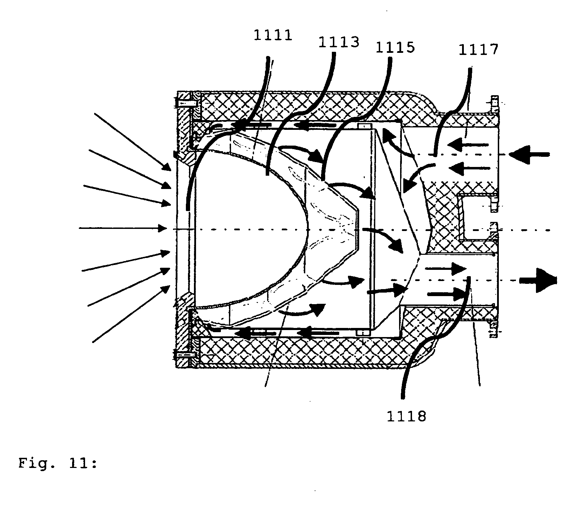

Zudem sind verschieden Receivertechnologien bekannt, insbesondere der in Fig. 11 gezeigte Hohlraumreceiver.

**Receiver**

Es gibt Receiver, wie in Fig. 1 dargestellt, bei denen die Mantelfläche die Absorberfläche darstellt, wie bereits erläutert. Andere Receiver haben eine Zielfläche, also Apertur oder Absorberfläche, deren Flächennormalen im Wesentlichen in die gleiche Richtung gerichtet sind.

In Fig. 11 ist der Querschnitt eines aus [9] bekannten Hohlraumreceivers zu sehen. Konzentrierte solare Strahlung fällt durch die Apertur 1111 in den Hohlraumreceiver und trifft dort auf den Absorber 1115, an dem die Wärme eines Wärmeträgermediums zugeführt wird. In dem gezeigt System ist das Wärmeträgermedium Luft, die durch den Einlass 1117 in den Receiver kommt und diesen erwärmt durch den Auslass 1118 verlässt. Diese Art von Receiver hat zudem eine Glaskuppel 1113, um die Luft im Receiver zu halten. Das Prinzip eines Hohlraumreceivers ist auch aus der Patentschrift US 4 220 140 bzw. WO 2008/153922 A1 bekannt.

**Aufgabe, Lösung und Vorteile der Erfindung**

Aufgabe der Erfindung ist es, ein solares Zentralreceiversystem zu bauen, bei dem das Heliostatenfeld effizienter genutzt werden kann.

Diese Aufgabe wird gelöst durch ein solares Zentralreceiversystem mit einem He-liostatenfeld nach Anspruch 1 und ein Verfahren zur Auslegung eiAnspruch 2

Demnach kann der eine oder die mehreren Receiver über ein Heliostatenfeld gehalten werden, so dass Heliostaten auch direkt unterhalb des Receiver installiert werden können. Bei einem nach unten ausgerichteten Receiver haben Heliostaten in der Region unterhalb des Receivers besonders hohe Wirkungsgrade. Durch die Installation von Heliostaten mit rechteckigen Reflektoren, bei denen die erste Drehachse parallel zu der Aufstellfläche ist, Heliostaten mit fester Horizontalachsen-Aufhängung (FHA), können die Heliostaten mit gemeinsamer Aufstellfläche mit sehr hoher Aufstelldichte in Reihen (bevorzugt in Ost-West-Richtung) installiert werden.

Durch die Verwendung von rechteckigen Reflektoren, bei denen der Reflektor in Richtung der zweiten Drehachse bevorzugt länger ist als in der dazu senkrechten Richtung, können die Abstände zwischen den Heliostatenreihen (bevorzugt in Nord-Süd-Richtung) um so mehr reduziert werden, je größer das Verhältnis der Seitenlängen ist, wie in Fig. 10 in [8] dargestellt und den dazugehörigen Erläuterungen hergeleitet. Dadurch ist es möglich, viele Heliostaten in der Region unterhalb des Receivers, in der diese einen besonders hohen Wirkungsgrad haben, mit einer Reflektorflächendichte $\varrho$ von $\varrho > 60\%$ zu installieren und diese Region optimal zu nutzen. Das Heliostatenfeld erstreckt sich somit kontinuierlich durchgehend in Nord-, Ost-, Süd- und West-Richtung, wie in Anspruch 14 aufgeführt. Mit zunehmendem Abstand von dieser Region nimmt der Wirkungsgrad ab. Mit zunehmender Anzahl an Heliostaten nimmt die Strahlungsleistung auf dem Receiver zu, jedoch nimmt die Leistungszunahme pro Heliostat mit jedem weiteren jeweils weniger effizienten Heliostaten ab. Durch die effiziente Nutzung der Region unterhalb des Receivers, die sich im Nahfeld des Heliostatenfeldes befindet, werden insgesamt weniger Heliostaten benötigt, als bei Solarturmkraftwerken mit umgebendem Heliostatenfeld, um die gleiche Strahlungsleistung auf dem Receiver zu erreichen.

Die Installation der Heliostaten in Reihen (Anspruch 2) ermöglicht die hohe Aufstelldichte im Nahfeld (Anspruch 3). Heliostaten in Ost-West-Reihen (Anspruch 4) sind die bevorzugte Auslegung, wobei die Ausrichtung der Reihen in Nord-Süd-Richtung ebenfalls sinnvoll ist und zu nahezu den gleichen Wirkungsgraden wie Heliostatenreihen in Ost-West-Richtung führt.

Bei Anwendungen, wo die Aufstellfläche der Heliostaten zur Gesamtgrundfläche um den Winkel $\alpha$ geneigt ist (Anspruch 5), ist eine Ausrichtung der Heliostaten-Reihen in Nord-Süd-Richtung eine sinnvolle Lösung für Heliostaten mit fester Quasipolarachsen-Aufhängung (FQA), durch die ebenfalls hohe Reflektorflächendichten im Nahfeld (Anspruch 6) erzielt werden können. Zudem können für die Tragsysteme solcher Heliostaten vergleichbare Montagesystem verwendet werden, die für die feste Montage von Photovoltaik-Modulen in Solarparks entwickelt wurden. Zudem bietet die Möglichkeit der mechanischen Koppelung der Heliostaten (Anspruch 7) potentielle Kostenersparnisse.

Es gibt verschiedene Tragstrukturen, um den Receiver oberhalb des Heliostatenfeldes zu halten. In Anspruch 8 wird ein Bogensystem, in Anspruch 9 ein Sprengwerk (dreieckförmige Tragstruktur) genannt, welche beide eine stützende Statik haben während das System in Anspruch 10 eine abgehängte Seilkonstruktion hat, bei der die Fußpunkte ebenso wie beim Bogen und Sprengwerk bevorzugt außerhalb des Heliostatenfeldes installiert sind, so dass der Receiver an einem Seilsystem über dem Heliostatenfeld hängt. Die Tragstruktur in Anspruch 11 basiert auf dem Konzept eines Turmdrehkrans, bei dem ein Ausleger oder Kragarm den Receiver über dem Heliostatenfeld hält. Dieses System ist vor allem bei kleinen solaren Zentralreceiversystemen geeignet, bei denen die Receiverhöhe $H_R$ weniger als ca. 70 m beträgt. Da bei kleinen Systemen die Länge des Auslegers eines üblichen Turmdrehkrans ausreichend ist, um den Fußpunkt jenseits des Heliostatenfeldes auf der vom Äquator abgewandten Seite des Receivers zu haben, kann so das Verschatten des Heliostatenfeldes durch die Tragstruktur des Receivers reduziert werden. Zudem erlaubt die Verwendung eines Turmdrehkrans den Receiver in drei Dimensionen zu bewegen (Anspruch 12), wie eine Last die von einem Turmdrehkran bewegt wird, und so den Wirkungsgrad des Heliostatenfeldes durch eine optimierte Positionierung des Receivers zu erhöhen.

Der Receiver ist an den jeweiligen Tragstrukturen so montiert, dass er an der lokalen Unterseite der Tragstruktur angebracht ist, so dass die Tragstruktur nicht die vom Heliostatenfeld reflektierte Strahlung blockiert (Anspruch 13).

Im Nahbereich ist eine hohe unveränderliche Reflektorflächendichte möglich, mit zunehmenden Abstand vom Receiver müssen die Heliostaten jedoch mit zunehmendem Abstand installiert werden, um zu vermeiden, dass die Heliostaten sich gegenseitig blockieren, d.h. dass ein Heliostat einen Teil der solaren Strahlung nicht auf den Receiver reflektieren kann, da ein anderer Heliostat den Strahlengang zum Receiver stört und somit blockiert. Zwar transferiert das Nahfeld bereits einen großen Teil der Strahlungsleistung auf den Receiver, dennoch wird ein Fernfeld benötig (Anspruch 15), um höherer Strahlungsleistungen von über 100 $MW_{th}$ auf dem Receiver in einer Receiverhöhe $H_R$ von über 100 m zu erzielen. Dieses Fernfeld kann aber durch die Leistung des Nahfeldes wesentlich kleiner ausfallen als bei anderen Solarturmsystem mit Strahlungsleistungen von über 100 $MW_{th}$ auf Receivern in einer Receiverhöhe $H_R$ von über 100 m, die Fernfelder als umgebende Heliostatenfelder ohne Nahfelder haben. Dadurch haben diese Systeme Heliostatenfelder mit wesentlich größeren Durchmessern $D_H$ von mehr als sechs Receiverhöhen $H_R$. Die Besonderheit des erfindungsgemäßen Systems ist die Möglichkeit, große solare Zentralreceiversysteme mit Receiverhöhen von über 100 m zu entwickeln, deren Durchmesser $D_H$ kleiner als sechs Receiverhöhen sind, wie im Anspruch 17 ausgeführt. Das bedeutet, dass diese Erfindung nicht nur zur effizienteren Nutzung der Heliostaten sondern auch zur effizienteren Nutzung der Grundfläche führt.

Das erfindungsgemäße solare Zentralreceiversystem unterscheidet sich von bisher bekannten Solarturmsystemen 1 bis 4 in folgender Weise.

1. Solarturmsystem mit umgebendem Heliostatenfeld

a. Das erfindungsgemäße System hat ein Nahfeld, das sich unterhalb des Receivers erstreckt, in dem Heliostaten mit höchstem Wirkungsgrad installiert werden mit Reflektorflächendichte $\varrho$ größer als 60% mit Heliostaten, die rechteckige Reflektorflächen und Heliostaten mit fester Horizontalachsen-Aufhängung (FHA) oder fester Quasipolarachsen-Aufhängung (FQA) aufweisen.

b. Das Heliostatenfeld ist durchgehend und nicht unterbrochen, wie das umgebende Heliostatenfeld, welches im Bereich um den Turm herum eine Aussparung hat, dort wo das erfindungsgemäße System Heliostaten mit dem höchsten Wirkungsgrad hat.

c. Das erfindungsgemäße System hat einen Receiver mit nach unten gerichteter Apertur oder Absorber-Fläche welches nicht nur insofern vorteilhaft ist, dass so Heliostaten mit höchsten Wirkungsgrad im Nahfeld installiert werden können, sondern auch noch insofern, dass die Konvektions- und Strahlungsverluste bei einem nach unten zum Heliostatenfeld gerichteten Receiver minimiert sind.

d. Der Receiver ist an eine Tragstruktur hängend montiert, die über das Heliostatenfeld reicht, was es ermöglicht, den Receiver auf eine Nahfeld unterhalbe des Receivers auszurichten, was zu höheren Wirkungsgraden der Heliostaten im Nahfeld führt.

e. Das erfindungsgemäße System hat wesentlich kleinere Heliostatenfelder im Sinne kleinerer Reflektorfläche und kleinerer Grundfläche bei gleicher Strahlungsleistung auf der Zielfläche des Receivers zum Auslegungszeitpunkt.

2. Solarturmsystem mit Nordfeld.

a. Das erfindungsgemäße System hat ein Nahfeld, das sich unterhalb des Receivers erstreckt, mit Reflektorflächendichte e größer als 60% mit Heliostaten, die rechteckige Reflektorflächen und Heliostaten mit fester Horizontalachsen-Aufhängung (FHA) oder fester Quasipolarachsen-Aufhängung (FQA) aufweisen.

b. Das Heliostatenfeld erstreckt sich in alle Himmelsrichtungen vom Receiver aus.

c. Das erfindungsgemäße System hat einen Receiver mit nach unten gerichteter Apertur oder Absorber-Fläche.

d. Der Receiver ist an eine Tragstruktur hängend montiert, die über das Heliostatenfeld reicht.

3. Solarturmsystem mit Heliostatenfeld unterhalb des Receivers

a. Das erfindungsgemäße System hat zusätzlich zum Nahfeld auch ein Fernfeld mit abnehmender Reflektorflächendichte $\varrho$ , wodurch große solare Zentralreceiversysteme mit Receiverhöhen $H_R$ von über 100 m und Strahlungsleistungen von über 100 $MW_{th}$ möglich sind. Bisherige Solarturmsysteme mit Heliostatenfeld unterhalb des Receivers haben Receiverhöhen $H_R$ von weniger als 30 m und kein Fernfeld.

b. Das erfindungsgemäße solare Zentralreceiversystem sieht für kleine Receiverhöhen $H_R$ von weniger als 70 m ein Turmdrehkransystem als Tragstruktur für den Receiver vor, das außerhalb des Heliostatenfelds auf der vom Äquator abgewandten Seite des Receivers seinen Fußpunkt hat und dessen Receiverposition mit der Position der Sonne in bis zu drei Dimensionen verändert werden kann.

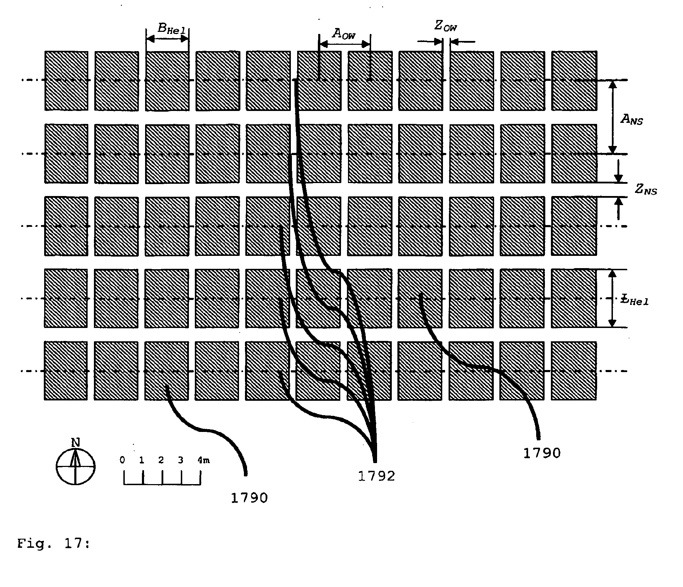

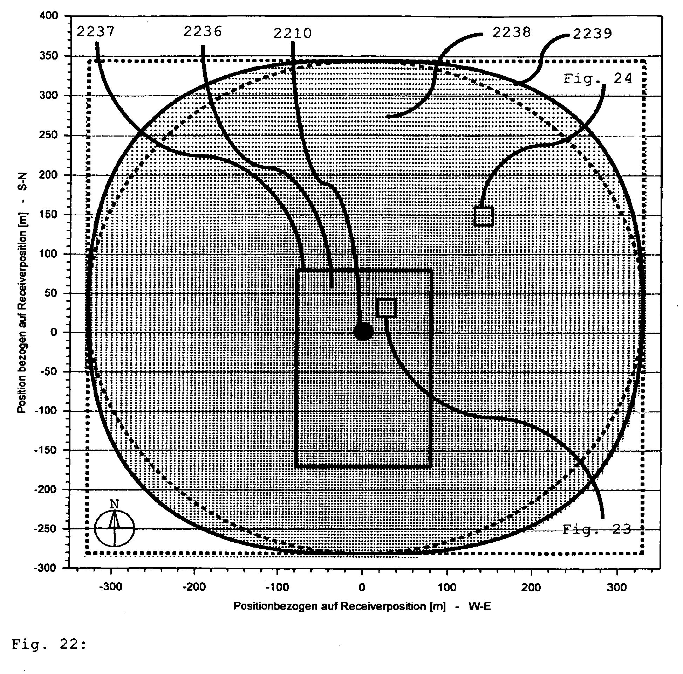

c. Das erfindungsgemäße System hat ein Nahfeld mit Reflektorflächendichte $\varrho$ größer als 60% mit Heliostaten, die rechteckige Reflektorflächen und Heliostaten mit fester Horizontalachsen-Aufhängung (FHA) oder fester Quasipolarachsen-Aufhängung (FQA) aufweisen. In Fig. 17 ist die Draufsicht eines Nahfeldes mit Heliostaten mit FHA und 68% Reflektorflächendichte und in Fig. 22 ein Heliostatenfeld mit Heliostaten mit FQA und einem Nahfeld mit einer Reflektorflächendichte von ca. 71% dargestellt.

4. Solarturmsystem mit Nord- und Südfeld,

a. Das erfindungsgemäße System hat ein Nahfeld mit Reflektorflächendichte $\varrho$ größer als 60% mit Heliostaten, die rechteckige Reflektorflächen und Heliostaten mit fester Horizontalachsen-Aufhängung (FHA) oder fester Quasipolarachsen-Aufhängung (FQA) aufweisen.

b. Das erfindungsgemäße System hat ein Fernfeld mit abnehmender Reflektorflächendichte $\varrho$ .

c. Das erfindungsgemäße System hat einen Receiver mit nach unten gerichteter Apertur oder Absorber als Zielfläche.

d. Der Receiver ist an eine Tragstruktur hängend montiert, die über das Heliostatenfeld reicht.

Keines der oben genannten vier Solarturmsysteme hat ein Nahfeld mit Reflektorflächendichte $\varrho$ größer als 60% mit Heliostaten, die rechteckige Reflektorflächen und Heliostaten mit fester Horizontalachsen-Aufhängung (FHA) oder fester Quasipolarachsen-Aufhängung (FQA) aufweisen.

## Kurze Beschreibung der Zeichnungen

In den Zeichnungen werden in den Figuren die gleichen Bezugszeichen für denselben Sachverhalt verwendet, wobei wenn die beiden letzten Endziffern der Bezugsziffern gleich sind, ähnliche Sachverhalte dargestellt werden. Die vor den beiden Endziffern stehenden Ziffern, bezeichnen die Nummer der jeweiligen Figur.

In den Zeichnungen zeigen:

Fig. 1 eine perspektivische Ansicht eines bekannten Solarturmsystems mit einem Heliostatenfeld, welches sich aus einer Vielzahl von Heliostaten zusammensetzt, die die solare Strahlung auf einen Receiver konzentrieren, der sich auf einem Turm befindet (Stand der Technik gemäß US 4 172 443),

Fig. 2 eine Prinzipdarstellung einer Draufsicht auf ein bekanntes Solarturmsystem mit umgebendem Heliostatenfeld (Stand der Technik),

Fig. 3 eine Prinzipdarstellung einer Draufsicht auf ein bekanntes Solarturmsystem mit einem Polarfeld, in diesem Fall für ein System auf der nördlichen Hemisphäre mit dem Heliostatenfeld nördlich vom Receiver und Turm. (Stand der Technik),

Fig. 4 eine Prinzipdarstellung einer Draufsicht auf ein bekanntes Solarturmsystem von Giovanni Francia mit Heliostatenfeld unterhalb des Receivers (Stand der Technik),

Fig. 5 eine perspektivische Ansicht eines bekannten Solarturmsystems mit Heliostatenfeld unterhalb des Receivers, der an eine Auslegertragstruktur hängend montiert ist (Stand der Technik gemäß US 4 220 140),

Fig. 6 eine Draufsicht auf ein bekanntes Solarturmsystem mit Nord- und Südfeld (Stand der Technik aus [7] und WO 2008/154521 A1),

Fig. 7 a) und b), je eine Prinzipiendarstellung eines bekannten Heliostaten mit fester Vertikalachsen-Aufhängung (FVA) und c) eine perspektivische Ansicht des vom frei beweglichen Reflektors benötigten Raumvolumens (Stand der Technik aus [8] und WO 2008/092195 A1),

Fig. 8 eine Prinzipiendarstellung einer Draufsicht auf die Aufstellung von Heliostaten mit fester Vertikalachsen-Aufhängung (FVA) mit maximaler Reflektorflächendichte bei Vermeidung überlappender Raumvolumina (Stand der Technik gemäß [8]),

Fig. 9     a) eine Prinzipiendarstellung eines bekannten Heliostaten mit fester Horizontalachsen-Aufhängung (FHA) und b) eine perspektivische Ansicht des vom frei beweglichen Reflektors benötigten Raumvolumens (Stand der Technik aus [8] und WO 2008/092195 A1),

Fig. 10    eine Prinzipiendarstellung einer Draufsicht auf die Aufstellung von Heliostaten mit fester Horizontalachsen-Aufhängung (FHA) mit maximaler Reflektorflächendichte bei Vermeidung überlappender Raumvolumina (Stand der Technik gemäß [8]),

Fig. 11    einen Querschnitt durch einen aus [9] bekannten Hohlraumreceiver bei dem die konzentrierte solare Strahlung durch die Apertur in den Hohlraumreceiver fällt und dort auf den Absorber trifft, an dem die Wärme einem Wärmeträgermediums zugeführt wird,

Fig. 12    eine perspektivische Ansicht einer erfindungsgemäßen Ausführungsform eines Modules von Heliostaten mit fester Quasipolarachsen-Aufhängung (FQA), bestehend aus fünf Gruppen von Heliostaten mit jeweils sechs Heliostaten einem gemeinsamen Tragsystem bestehend aus Tragrahmen und Beinen, wobei die erste Drehachse, die fest mit der Aufstellfläche verbunden ist, parallel zu der Aufstellfläche ist, die in der Abbildung durch den Tragrahmen aufgespannt wird und die um den Winkel $\alpha$ zur Gesamtgrundfläche des Heliostatenfeldes geneigt ist,

Fig. 13    eine Draufsicht auf eine erfindungsgemäße Ausführungsform einer Gruppe von Heliostaten bestehend aus sechs Heliostaten mit fester Quasipolarachsen-Aufhängung (FQA), wobei das Raumvolumen der Heliostaten eine dichte Positionierung der Heliostaten innerhalb der dargestellten Gruppe von Heliostaten erlaubt und die Nachführung der Heliostaten über die erste Drehachse direkt und die Nachführung über die zweiten Drehachsen 1393, die parallel sind, über eine gemeinsame Mechanik mechanisch gekoppelt sind,

Fig. 14    eine Übersicht über mögliche Trägstrukturen der erfindungsgemäßen Ausführungsformen des solaren Zentralreceiversystems mit jeweils hängend montiertem Receiver mit a) bogenförmiger Tragstruktur, b) einem Sprengwerk (dreieckförmige Tragstruktur), c) einer abgehängten Seilkonstruktion und d) ein Kransystem als Tragstruktur bestehend aus einer vertikalen Tragstruktur und einem Ausleger oder Kragarm, an dem der Receiver hängend montiert ist,

Fig. 15    a) einen Querschnitt durch eine erfindungsgemäße Ausführungsform eines Hohlraumreceiver und b) eine perspektivische Ansicht der Unterseite dieses Hohlraumreceivers, bei sich dem der Absorber in einem Hohlraum befindet, wobei die solare Strahlung durch die optische Öffnung, die Apertur, in den Hohlraum dringt und dort auf den Absorber fällt,

Fig. 16    eine Draufsicht auf eine erfindungsgemäße Ausführungsform eines solaren Zentralreceiversystems mit Aufteilung des Heliostatenfeldes aus Heliostaten mit FHA in Nah- und Fernfeld, wobei das Nahfeld sich unterhalb des Receivers bis zur rechteckigen Umrandung erstreckt und das Fernfeld sich vom Rand des Nahfeldes bis zur Umrandung des Heliostatenfeldes erstreckt,

Fig. 17    einen vergrößerten Ausschnitt der Draufsicht auf die erfindungsgemäße Ausführungsform von Fig. 16 zur Darstellung der Aufstellung der Heliostaten mit FHA im Nahfeld,

Fig. 18    einen vergrößerten Ausschnitt der Draufsicht auf die erfindungsgemäße Ausführungsform von Fig. 16 zur Darstellung der Aufstellung der Heliostaten mit FHA im Fernfeld, wobei die Abstände nicht maßstäblich sind und n die Nummerierung der Heliostatenreihen in West-Ost-Richtung und m die Nummerierung der Heliostatenreihen in Süd-Nord-Richtung ist.

Fig. 19    ein Diagramm für die Abstände der Heliostaten in Ost-West- und in Nord-Süd-Richtung in Abhängigkeit vom Abstand vom Receiver,

Fig. 20    a) einen Querschnitt durch eine erfindungsgemäße Ausführungsform eines Receivers mit externem Absorber und b) eine perspektivische Ansicht der Unterseite des Receivers mit externem Absorber, bei dem der Absorber eine Seite des Receivers darstellt,

Fig. 21    eine perspektivische Darstellung der erfindungsgemäßen Ausführungsform von vier Reihen von je vier Modulen von Heliostaten mit FQA, aufgestellt in parallelen Ost-West-Reihen,

Fig. 22    eine Draufsicht auf eine erfindungsgemäße Ausführungsform eines solaren Zentralreceiversystems mit Heliostaten mit FQA, wobei jeder Punkt einer Gruppe von Heliostaten wie in Fig. 13 gezeigt entspricht, mit Aufteilung des Heliostatenfeldes in Nah- und Fernfeld, wobei das Nahfeld sich unterhalb des Receivers bis zur rechteckigen Umrandung erstreckt und das Fernfeld sich vom Rand des Nahfeldes bis zur Umrandung des Heliostatenfeldes erstreckt,

Fig. 23    einen vergrößerten Ausschnitt der nicht maßstäblichen Draufsicht auf die erfindungsgemäße Ausführungsform von Fig. 22 zur Darstellung der Aufstellung der Heliostaten mit FQA im Nahfeld, wobei die Abstände $A_{Mod}$ der Modulreihen in Nord-Süd-Richtung gleich sind im Nahfeld, so wie die Abstände $A_{OW}$ der Heliostaten innerhalb der Modulreihen in Ost-West-Richtung,

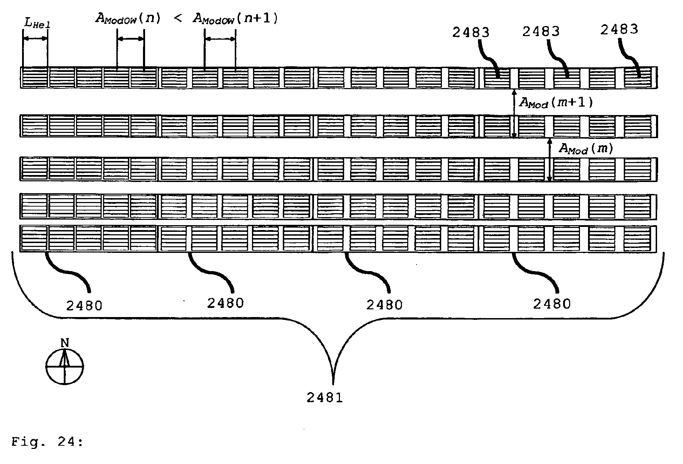

Fig. 24    einen vergrößerten Ausschnitt der nicht maßstäblichen Draufsicht auf die erfindungsgemäße Ausführungsform von Fig. 22 zur Darstellung der Aufstellung der Heliostaten mit FQA im Fernfeld, wobei die Abstände $A_{Mod}$ der Modulreihen in Nord-Süd-Richtung mit Abstand vom Receiver zunehmen, wie die Abstände der Heliostaten innerhalb der Modulreihen in Ost-West-Richtung, wobei innerhalb eines Modules die Abstände der Heliostaten Ost-West-Richtung gleich bleiben können und der Winkel $\alpha$ mit dem Abstand vom Receiver größer wird, wodurch die Modulreihen in der Draufsicht mit Abstand vom Receiver zunehmend schmaler erscheinen, so dass $A_{Mod}(m) < A_{Mod}(m+1)$ und $A_{ModOW}(n) < A_{ModOW}(n+1)$, wobei n die Nummerierung der Module in West-Ost-Richtung und $m$ die Nummerierung der Modulreihen in Süd-Nord-Richtung ist,

Fig. 25    ein Diagramm für die Abstände der Heliostaten in Ost-West- und in Nord-Süd-Richtung in Abhängigkeit vom Abstand vom Receiver für ein Heliostatenfeld mit Heliostaten mit FQA und Darstellung des Winkels $\alpha$ der jeweiligen Module des Heliostatenfeldes in Abhängigkeit vom Abstand vom Receiver in Nord-Süd-Richtung, wobei positive Werte bedeuten, dass die Drehachse so gekippt ist, dass das höhere Ende Richtung Erdpol zeigt, während negative Werte bedeuten, dass das höhere Ende der Drehachse Richtung Äquator zeigt,

Fig. 26    einen Querschnitt einer erfindungsgemäßen Ausführungsform eines solaren Zentralreceiversystems mit Heliostatenfeld und Turmdrehkran als Tragstruktur dessen Darstellung aus [10] entnommen wurde, bestehend aus einer vertikalen Tragstruktur und einem Ausleger für den Receiver und einem Feld aus Heliostaten mit FHA, bestehend aus Nahfeld ohne Fernfeld, wobei die Position des Receivers drei Dimensionen verändert werden kann,

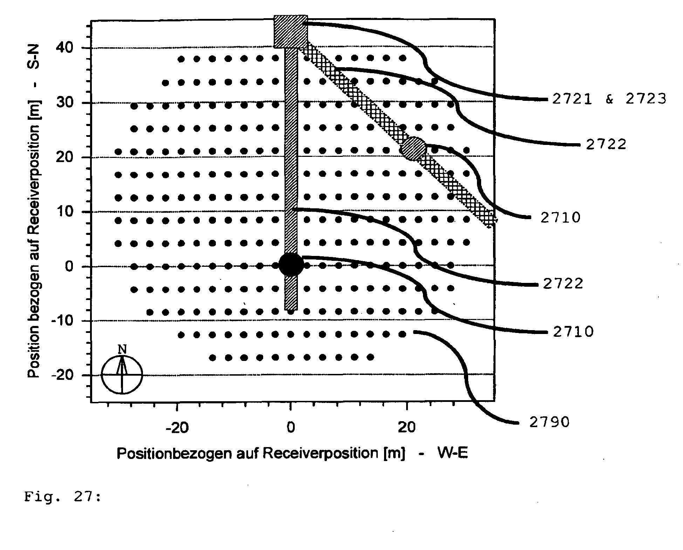

Fig. 27    eine Draufsicht auf eine erfindungsgemäße Ausführungsform eines solaren Zentralreceiversystems mit Heliostatenfeld, wobei jeder Punkt einem Heliostaten entspricht, und Turmdrehkran als Tragstruktur, bestehend aus vertikale Tragstruktur und Fußpunkt nördlich außerhalb des Heliostatenfeldes und einem Ausleger, um den Receiver über dem Heliostatenfeld zu halten, wobei der Ausleger kann durch eine vertikale Drehachse Achse in der vertikalen Tragstruktur gedreht und der Receiver entlang des Auslegers vor und zurück bewegt werden kann, wie exemplarische dargestellt, wobei die Position, in der sich der Receiver über dem Nullpunkt des Heliostatenfeldes befindet, die Situation ist, bei der die Sonne sich mittags genau südlich vom Heliostatenfeld befindet, während die andere Position die Situation darstellt, wenn sich die Sonne im Sommer morgens nord-östlich vom Heliostatenfeld befindet.

## **Erfindung**

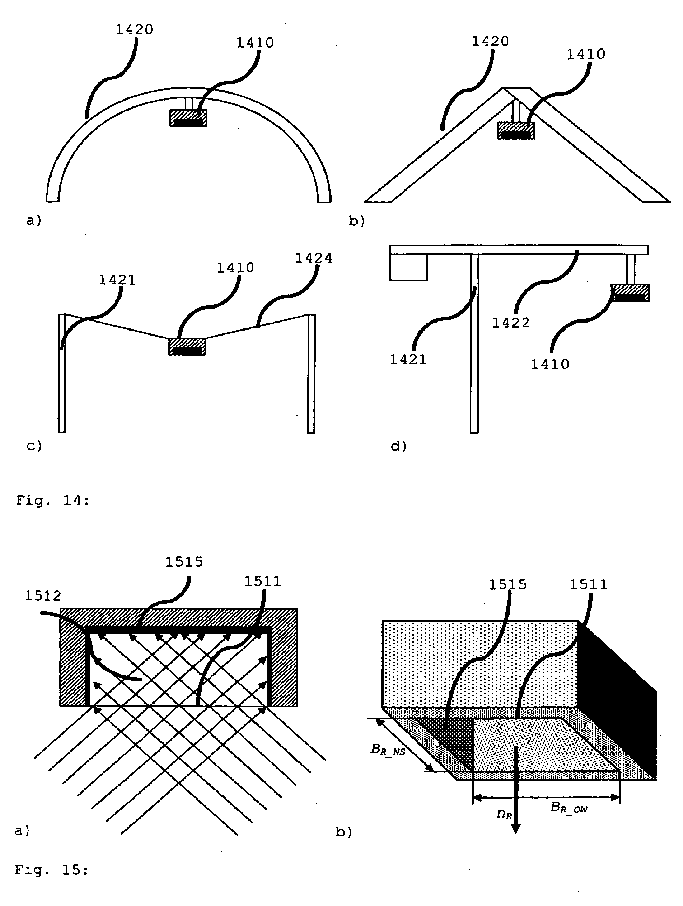

Ziel der Erfindung ist es, solare Zentralreceiverkraftwerke zu bauen, bei denen die Heliostatenfelder effizienter genutzt werden können. Dafür wird ein Heliostatenfeld bestehend aus einem Nahfeld mit gleichmäßiger Reflektorflächendichte $\varrho$ von mehr als 60% und vorzugsweise mit einem Fernfeld, dessen Reflektorflächendichte $\varrho$ mit zunehmendem Abstand vom Receiver abnimmt, kombiniert. Die Erfindung umfasst auch solare Zentralreceiversysteme die ausschließlich aus einem Nahfeld mit gleichmäßiger Reflektorflächendichte $\varrho$ von mehr als 60%. Die hohe Reflektorflächendichte $\varrho$ im Nahfeld und Bereichen des Fernfeldes wird durch den Einsatz von Heliostaten mit rechteckigen Reflektoren und fester Horizontalachsen-Aufhängung (FHA) oder alternativ Heliostaten mit rechteckigen Reflektoren und fester Quasipolarachsen-Aufhängung (FQA) erreicht. Heliostaten mit fester Horizontalachsen-Aufhängung sind in WO 02/070966 A1, WO 2008/092194 A1, WO 2008/092195 A1 und [8] beschrieben. Heliostaten mit fester Quasipolarachsen-Aufhängung (FQA) werden in dieser Erfindung zum ersten Mal beschrieben. Das Heliostatenfeld konzentriert die solare Strahlung auf einen Receiver, dessen Zielfläche, die Apertur, der thermische Absorber oder der photovoltaische Absorber, einen Normalenvektor hat der nach unten auf das Heliostatenfeld gerichtet ist, das sich unterhalb des Receivers in Nord-, Ost-, Süd- und West-Richtung erstreckt. Der Receiver ist an eine Tragstruktur hängend montiert, die sich über das Heliostatenfeld erstreckt. Diese Tragstruktur kann zum Beispiel ein Bogen (siehe Fig. 14a), ein Sprengwerk (siehe Fig. 14b) oder eine abgehängte Seilkonstruktion (siehe Fig. 14c) mit mehreren Fußpunkten oder ein Kransystem mit Ausleger oder Kragarm und einem Fußpunkt (siehe Fig. 14d) sein. Idealerweise liegen die Fußpunkte außerhalb des Heliostatenfeldes, können aber auch innerhalb des Feldes sein, zum Beispiel aus statischen Gründen.

Die Erfindung ermöglicht solare Zentralreceiversysteme mit Receiverhöhen $H_R$ von über 100 m mit Strahlungsleistungen auf der Zielfläche des Receivers von über 100 MW$_{th}$ zum Auslegungszeitpunkt (typischer Weise am Tag der Sommersonnenwende um 12 Uhr mittags, Sonnenzeit) und einer Größe des Heliostatenfeldes dessen Durchmesser $D_H$ kleiner als sechs Receiverhöhen $H_R$ beträgt. Das bedeutet, dass diese Erfindung nicht nur zur effizienteren Nutzung der Heliostaten, sondern auch zur effizienteren Nutzung der Grundfläche führt.

**Heliostaten mit fester Quasipolarachsen-Aufhängung (FQA)**

Ein alternativer erfindungsgemäßer Heliostat für Heliostatenfelder mit hoher Reflektorflächendichte ist der Heliostat mit fester Quasipolarachsen-Aufhängung (FQA). Der Heliostat mit FQA ist eine Weiterentwicklung des Heliostaten mit FHA.

In Fig. 12 ist ein Modul 1280 von Heliostaten mit fester Quasipolarachsen-Aufhängung (FQA) dargestellt, bei denen die erste Drehachse 1292 mit dem Rahmen 1285 des Moduls so fest verbunden ist, dass diese erste Drehachse 1292 gegenüber der Gesamtgrundfläche, auf der die Beine 1287 des Moduls 1280 fußen, um einen in Fig. 12 eingezeichneten Winkel $\alpha$ geneigt ist. Die zweiten Drehachsen 1293 liegen senkrecht zur ersten und bewegen sich mit den Reflektoren 1295, mit denen sie fest verbunden sind, um die erste Drehachse 1292. Ein Heliostat mit FQA ist somit eine Weiterentwicklung eines Heliostaten mit FHA, bei dem die Aufstellfläche, zu der die erste Drehachse 1292 parallel fest verbunden ist, um einen Winkel $\alpha$ gegenüber der Gesamtgrundfläche geneigt ist. Dabei ist die geneigte Aufstellfläche gleich der Fläche, die in Fig. 12 durch den Rahmen 1285 des Modulsystems aufgespannt wird.

In der in Fig. 12 dargestellten bevorzugten Ausführung ist die durch den Modulrahmen 1285 aufgespannte Aufstellfläche um die Ost-West-Achse gegenüber der Gesamtgrundfläche gekippt und die erste Drehachse 1292 in Nord-Süd-Richtung ausgerichtet. Durch die Bewegung um die erste Drehachse 1292 folgen die Heliostaten vor allem dem Tagesgang der Sonne in Ost-West-Richtung, während die Heliostaten durch die Bewegung um die zweite Drehachse 1293 vor allem der Höhe der Sonne folgen.

In der Ausführung in Fig. 12 bilden jeweils sechs Heliostaten mit FQA und einer gemeinsamen Aufstellfläche jeweils eine Gruppe von Heliostaten 1283. Fünf solcher Gruppen von Heliostaten bilden mit einem gemeinsamen Tragsystem ein Modul.

Fig. 13 zeigt die Draufsicht auf eine Gruppe von Heliostaten 1383 aus sechs Heliostaten 1390 mit FQA. Das Raumvolumen 1399 der Heliostaten 1390 erlaubt eine dichte Positionierung der Heliostaten innerhalb der dargestellten Gruppe von Heliostaten. Die Nachführung der Reflektoren der Heliostaten kann über die erste Drehachse 1392 gekoppelt sein. Ebenso kann die Bewegung um die zweiten Drehachsen 1393, die parallel sind, über eine gemeinsame Mechanik 1394 gekoppelt werden.

In der in Fig. 12 und Fig. 13 dargestellten bevorzugten Ausführung sind Gruppen von Heliostaten 1283 und 1383 mit gemeinsamer Aufstellfläche in Reihen installiert, so dass sie eine gemeinsame erste Drehachse 1292 und 1392 haben, so dass die Bewegung um diese erste Drehachse 1292 und 1392 mechanisch gekoppelt ist. Die durch die Ausrichtung der Drehachsen definierten Raumvolumina 1299 und 1399 der Reflektoren 1295 und 1395 erlauben, wie bei den Heliostaten mit FHA, die hohe Aufstelldichte in Reihen.

Die Ausrichtung der gemeinsamen Aufstellfläche um den Winkel $\alpha$ und somit der dazu parallelen ersten Drehachse orientiert sich an der Erdachse, um die sich die Erde bewegt. In einer bevorzugten Ausführung wäre die erste Drehachse eines Heliostaten mit FQA mit einer Position auf der vom Äquator abgewandten Seite des Receivers im Wesentlichen parallel zur Erdachse, d.h. der Winkel $\alpha$ hätte im Wesentlichen den gleichen Betrag, wie der geographische Breitengrad an dem Standort. In anderen Positionen, nördlich oder südlich davon, ist der Winkel $\alpha$ größer oder kleiner. Mit zunehmendem Abstand vom Receiver zum nächsten Erdpol hin wäre die erste Drehachse zunehmend in die Vertikale gekippt, sprich der Winkel $\alpha$ wäre größer, während bei Heliostaten mit Positionen näher zum Äquator hin zunehmend in die Horizontale gekippt wäre, sprich der Winkel $\alpha$ kleiner wäre. Auf der dem Äquator zugewandten Seite des Receivers kann es Regionen geben, in denen die Aufstellfläche und die erste Drehachse in die andere Richtung gekippt sein können.

Der Winkel $\alpha$ der gemeinsamen Aufstellfläche einer Gruppe von Heliostaten und deren erste Drehachse wird so gewählt, dass die benachbarten Heliostaten innerhalb der Gruppe von Heliostaten eine hohe Aufstelldichte haben, ohne sich gegenseitig zu verschatten und zu blockieren. Dazu wird der Winkel $\alpha$ so gewählt, dass die Heliostaten bei Tagnachtgleiche im März und September um 12 Uhr mittags Sonnenzeit im Betrieb im Wesentlichen in einer Ebene liegen. Module mit Gruppen von Heliostaten mit FQA werden mit solchen Abständen in Nord-Süd-Richtung installiert, dass das gegenseitige Verschatten und Blockieren der Heliostaten gering ist. Blockieren bedeutet, dass ein Heliostat einen Teil der solaren Strahlung nicht auf den Receiver reflektieren kann, da ein anderer Heliostat den Strahlengang zum Receiver stört und somit blockiert, während Verschatten bedeutet, dass ein Heliostat einen anderen Heliostaten verschattet.

Die Bewegung der Heliostaten um die zweite Drehachse 1293 und 1393 kann ebenfalls mechanisch gekoppelt sein, muss aber nicht. In Fig. 13 ermöglicht die im Wesentlichen lineare Bewegung der Mechanik 1394 eine gemeinsame Bewegung der Heliostaten 1390 um deren zweite Drehachse 1393.

Die mechanische Koppelung von Heliostaten mit FHA in ähnlicher Form ist in Fig. 6 in WO 02/070966 A1 und den dazugehörigen Erläuterungen in ähnlicher Form dargestellt.

In der in Fig. 12 dargestellten bevorzugten Ausführung haben die Reflektoren 1295 eine längliche Form, so dass die Länge $L_{Hel}$ mindestens doppelt so groß ist wie die Breite $B_{HEL}$. In der Auslegung in Fig. 12 ist der Reflektor 1295 sogar mindestens sechsmal länger als breit ($L_{Hel} > 6 \times B_{HEL}$).

Die Reflektoren der Heliostaten können flach oder entlang der Länge konzentrierend gekrümmt sein.

Wie in Fig. 12 zu sehen, ermöglichen die sich aus der länglichen Form der Reflektoren ergebenden Raumvolumina eine hohe Aufstelldichte benachbarter Heliostatenreihen innerhalb eines gemeinsamen Moduls 1280. Die hohe Aufstelldichte länglicher rechteckiger Reflektoren von Heliostaten mit FHA ist in Fig. 10 in [8] dargestellt. Für Heliostaten mit FQA gelten die gleichen Zusammenhänge.

### Ausführungsbeispiele

### Ausführungsbeispiel 1

Eine beispielhafte Auslegung für ein solares Zentralreceiversystem auf Basis dieser Patentschrift wurde mit folgenden Eigenschaften ausgelegt:

### Annahmen für Auslegung des solaren Zentralreceiversystem

Auslegungszeitpunkt: 21. Juni, 12 Uhr mittags, Sonnenzeit.

Standort: Breitengrad 34° N, nördlicher Breitengrad, (z.B. Nordafrika oder Südkalifornien, USA).

Annahme: Direkt-Normal-Strahlung (solare Strahlungsleistung) zum Auslegungszeitpunkt: 1000 W/m$^2$.

Strahlungsleistung (thermische Leistung in Megawatt - MW$_{th}$) auf der Zielfläche des Receivers zum Auslegungspunkt: 140 MW$_{th}$.

### Receiver

Der verwendete Receiver ist ein Hohlraumreceiver, wie in Fig. 15 dargestellt, bei dem sich der Absorber 1515 in einem Hohlraum 1512 befindet. Die solare Strahlung dringt durch die optische Öffnung, die Apertur 1511, in den Hohlraum 1512 und fällt dort auf den Absorber 1515, der die solar Strahlung in Wärme wandelt. Der Absorber 1515 kann auch verschiedene Formen und Strukturen haben. Der Normalenvektor $n_R$ der Aperturfläche zeigt nach unten. $B_{R\_NS}$ ist die Breite der rechteckigen Apertur 1511 in Nord-Süd-Richtung und $B_{R\_OW}$ in Ost-West-Richtung. Für die Dimensionen der Apertur 1511 des Hohlraumreceivers gilt wie in Fig. 15 dargestellt:

$$B_{R\_NS} = 12{,}5 \text{ m}, \quad B_{R\_OW} = 12{,}5 \text{ m} \quad (156{,}25 \text{ m}^2)$$

Für die Höhe des Receivers über dem Heliostatenfeld der Receiverhöhe gilt $H_R$ = 150 m.

### Receiver-Tragstruktur

Der Receiver ist an eine Tragstruktur hängend montiert, die den Receiver frei über dem Heliostatenfeld hält. Dies kann zum Beispiel ein Bogensystem mit zwei Standfüßen sein, wie in Fig. 14a dargestellt. Der Bogen würde sich von Osten nach Westen über das Heliostatenfeld spannen.

### Heliostaten

Heliostaten mit fester Horizontalachsen-Aufhängung (FHA).

Reflektorfläche $F_{Hel}$ = $L_{Hel}$ x $B_{Hel}$ = 7,2225 m$^2$.

$L_{Hel}$ = 3,21 m (Länge), $B_{Hel}$ = 2.25 m (Breite).

Die Reflektoren der Heliostaten sind flach und nicht konzentrierend gekrümmt.

**Heliostatenfeld**

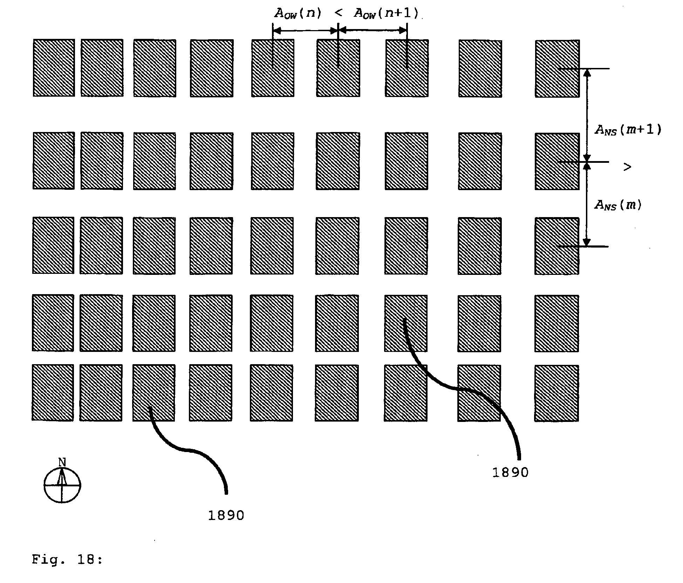

Die Heliostaten werden in parallelen Reihen in Ost-West-Richtung aufgestellt, wobei die Heliostaten auch in Nord-Süd-Richtung in Reihen stehen. Siehe Fig. 17 und Fig. 18. In anderen Auslegungen können die Heliostaten benachbarter Ost-West-Reihen auch um einen halben Heliostatenabstand $A_{OW}$ (vgl. Fig. 17) zueinander versetzt stehen, wie in Fig. 10.

Das Heliostatenfeld besteht aus einem Nahfeld 1636 und einem Fernfeld 1638.

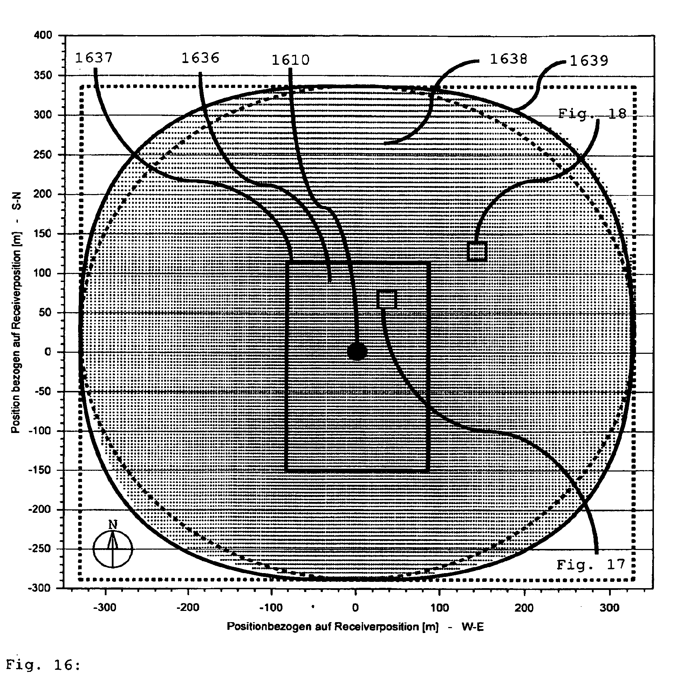

In Fig. 16 ist das beschriebene Heliostatenfeld, bestehend aus einem Nahfeld 1636 und dem Fernfeld 1638, in einer Draufsicht dargestellt, wobei jeder einzelne Punkt die Position eines einzelnen Heliostaten in Nord-Süd-Richtung und Ost-West-Richtung repräsentiert. Der Nullpunkt des Koordinatensystems ist durch die Position der Mitte des Receivers 1610, der hier durch einen größeren nicht maßstäblichen Punkt repräsentiert wird, definiert. Die äußere Umrandung des Nahfeldes 1637 ist zugleich die Grenze zum Fernfeld. Die äußere Umrandung des Fernfeldes ist zugleich die äußere Umrandung des gesamten Heliostatenfeldes 1639.

Im Nahfeld 1636 sind die Heliostaten in gleichbleibenden Abständen zueinander mit der maximalen Reflektorflächendichte $\varrho_{max}$ aufgestellt, wie aus dem vergrößerten Ausschnitt der Draufsicht auf das Nahfeld in Fig. 17 ersichtlich. Die Reflektorflächendichte $\varrho$ im Nahfeld ist gleich der maximalen Reflektorflächendichte $\varrho_{max}$ im Heliostatenfeld.

Der Nahbereich des Heliostatenfeldes erstreckt sich gemäß Fig. 16 in Ost-West-Richtung von 85 m östlich des Receivers bis 85 m westlich des Receivers und in Nord-Süd-Richtung von 115 m nördlich des Receivers bis 150 m südlich des Receivers.

In Fig. 17 ist ein Ausschnitt aus der Draufsicht eines Nahfeldes maßstabgerecht dargestellt mit den Abständen der Heliostaten 1790 in Ost-West- und in Nord-Süd-Richtung.

In Ost-West-Richtung sind die Heliostaten im Nahfeld mit Abständen $A_{OW}$ von 2,65 m aufgestellt, d.h. dass es zwischen den Reflektoren mit Breite $B_{Hel}$ von 2,25 m jeweils einen Zwischenraum $Z_{OW}$ von 0,4 m gibt, wenn diese sich in horizontaler Parkposition befinden bei der die Reflektoren horizontal sind und die lange Seite der Heliostaten in Nord-Süd-Richtung orientiert sind, wie in der Draufsicht in Fig. 17 dargestellt.

Die hohe Aufstelldichte innerhalb der Ost-West-Reihen von ca. 85% (=2,25 m/2,65 m) ist möglich durch die Verwendung von Heliostaten mit fester Horizontalachsen-Aufhängung (FHA), wie in WO 02/070966 A1, WO 2008/092194 A1 und WO 2008/092195 A1 beschrieben. Die feste Horizontalachsen-Aufhängung der Heliostaten erlaubt sogar eine grundsätzlich höhere Aufstelldichte innerhalb der Ost-West-Reihen, wenn die Installation und Fertigung präzise ist und lokale Sicherheitsstandards erfüllt sind. In Fig. 10 ist dargestellt wie Heliostaten 1090 mit FHA mit maximaler Aufstelldichte in Ost-West-Richtung ohne Toleranzen zwischen den Heliostaten aufgestellt werden können.

In Nord-Süd-Richtung sind die Heliostatenreihen im Nahfeld mit Abständen $A_{NS}$ von 4,01 m aufgestellt, d.h. dass es zwischen den Reflektoren mit der Länge $L_{Hel}$ = 3,21 m (und somit 3,21 m breiten Reihen) jeweils einen Zwischenraum $Z_{NS}$, von 0,8 m gibt, wenn diese sich in horizontaler Parkposition befinden. Siehe Fig. 17. Die Aufstelldichte der Reihen kann grundsätzlich auch höher sein, wenn die Heliostatenreihen um jeweils eine halben Heliostatenabstand $A_{OW}$ (vgl. Fig. 17) versetzt sind wie in Fig. 10 dargestellt.

Aus der Kombination der Aufstelldichte in Ost-West und in Nord-Süd ergibt sich im Nahfeld eine konstante Reflektorflächendichte von $\varrho_{max}$ = ca. 68%

Die konstante Reflektorflächendichte $\varrho$ im Nahfeld entspricht der maximalen Reflektorflächendichte $\varrho_{max}$, die im Nahfeld wie in Fig. 17 nach folgender Formel berechnet wird:

$$\varrho_{max} = \varrho = (B_{HEL} \times L_{HEL}) / (A_{OW} \times A_{NS}).$$

Mit rechteckigen Heliostaten mit fester Vertikalachsenaufhängung (wie es alle bekannten kommerziellen Heliostaten haben) kann im idealen Fall (quadratische Spiegel) eine theoretisch maximale Reflektorflächendichte von $\varrho_{max}$ = ca. 58% erreicht werden, wie in [8] erläutert und hergeleitet.

Im Fernfeld vergrößern sich die Abstände mit zunehmendem Abstand vom Receiver 1610 sowohl in Ost-West- als auch Nord-Süd-Ausrichtung. Im Fernfeld wachsen die Abstände $A_{OW}$ in Ost-West-Richtung von 2,65 m auf bis zu 5 m und die Abstände $A_{NS}$ in Nord-Süd-Richtung von 4,01 m auf bis zu 8 m.

In Fig. 18 ist ein vergrößerter Ausschnitt der Draufsicht eines Fernfeldes dargestellt. Die Darstellung der Abstände zeigt nur das Prinzip. Die Abstände sind nicht maßstabsgerecht. Es ist zu erkennen, dass für den dargestellten Fall, bei dem der Receiver 1610 sich südwestlich dieses Feldausschnittes befindet, die Abstände von Westen nach Osten und von Süden nach Norden zunehmen.

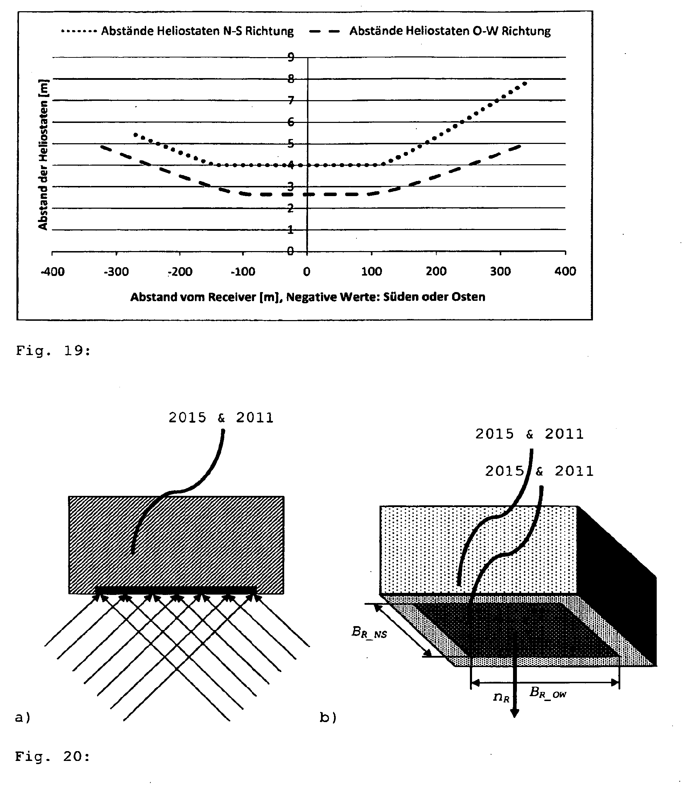

Die Zunahme der Abstände der Heliostaten in Ost-West- und Nord-Süd-Richtung ist in Fig. 19 dargestellt.

Das gesamte Heliostatenfeld erstreckt sich in Nord-Süd-Richtung von 340 m nördlich des Receivers 1610 bis zu 285 m südlich des Receivers 1610 und in Ost-West-Richtung von 330 m östlich des Receivers bis 330 m westlich des Receivers 1610.

Die Reflektorflächendichte für das gesamte Heliostatenfeld $\varrho_{Gesamt}$ beträgt $\varrho_{Gesamt} = 52\%$

Der Umfang des Heliostatenfeldes beschreibt in Fig. 16 eine Form, die außerhalb eines Kreises und gleichzeitig innerhalb eines Quadrates verläuft. Das Zentrum des Heliostatenfeldes liegt ca. 25 m nördlich des Receivers 1610, wie aus den in Fig. 16 eingezeichneten Maßstabsangaben ersichtlich ist. Der Receiver 1610 ist ca. 25 m aus dem Zentrum des Felds nach Süden verschoben. Der Durchmesser des Heliostatenfeldes ist ca. 700 m und somit ca. 4.5 x $H_R$.

Das Heliostatenfeld ist kontinuierlich durchgehend und lediglich dann nur für die Fußpunkte der Tragestruktur unterbrochen, sollte die technische Umsetzung der Spannweite der Tragstruktur Fußpunkte innerhalb des Heliostatenfeldes notwendig machen.

**Zusammenfassung der wesentlichen Merkmale zu Ausführungsbeispiel 1**

- Receiverhöhe $H_R$: 150 m über Heliostatenfeld.
- Fläche der Receiver-Apertur : 12,5m x 12,5m = 156,25 m$^2$.
- Receiver-Ausrichtung: Normalenvektor der Aperturfläche des Receivers 1610 senkrecht nach unten gerichtet wie in Fig. 15 dargestellt.
- Tragstruktur: Bogensystem, wie in Fig. 14a, Ost-West über Heliostatenfeld, bestehend aus Nahfeld 1636 und Fernfeld 1638, gespannt.
- Heliostatenfeld mit konstanter Reflektorflächendichte $\varrho$ im Nahfeld 1636, die gleich der maximalen Reflektorflächendichte $\varrho_{max}$ von ca. 68% ist.

  1. Heliostaten mit fester Horizontalachsen-Aufhängung für hohe Aufstelldichte innerhalb einer Reihe in Ost-West Richtung oder alternativ innerhalb einer Reihe in Nord-Süd-Richtung.

  2. Heliostatenfeld hat im Nahbereich Reflektorflächendichte $\varrho = \varrho_{max} = 68\% > 60\%$.

  3. Heliöstatenfeld, das sich in Nord-,Ost-, Süd- und West-Richtung um den Receiver erstreckt und eine kontinuierlich durchgehende (ununterbrochene) Fläche darstellt.

- Im Fernfeld zunehmende Abstände zwischen den Heliostaten in Ost-West und Nord-Südrichtung.
- Reflektorflächendichte für das gesamte Heliostatenfeld $\varrho_{Gesamt}$ beträgt $\varrho_{Gesamt} = 52\%$.
- Heliostaten mit fester Horizontalachsenaufhängung für hohe Aufstelldichte in Ost-West Richtung.
- Abmessungen des Nahfeldes 1636: 85 m östlich bis 85 m westlich vom Receiver und 115 m nördlich des Receivers und 150 m südlich des Receivers 1610.

**Ausführungsbeispiel 2**

Eine weitere beispielhafte Auslegung für ein solares Zentralreceiversystem auf Basis dieser Patentschrift unter der Verwendung des erfindungsgemäßen Typus von Heliostaten mit fester Quasipolarachsen-Aufhängung (FQA) wurde mit folgenden Eigenschaften ausgelegt:

**Annahmen für Auslegung des solaren Zentralreceiversystems**

Auslegungszeitpunkt: 21. Juni, 12 Uhr mittags, Sonnenzeit.

Standort: Breitengrad 34° N, nördlicher Breitengrad, (z.B. Nordafrika oder Südkalifornien, USA).

Annahme: Direkt-Normal-Strahlung (solare Strahlungsleistung) zum Auslegungszeitpunkt: 1000 W/m$^2$.

**Receiver**

Der verwendete Receiver ist ein Receiver mit externem Absorber, wie in Fig. 20 dargestellt, bei der einen Absorber 2015 auf einer Seite des Receivers. Die Oberfläche des Absorbers 2015 ist somit auch gleich der optischen Öffnung des Receivers, der Apertur 2011. In anderen Fällen kann der Absorber 2015 auch eine nicht flache Oberfläche haben. Der Normalenvektor $n_R$ der Absorberfläche zeigt nach unten. $B_{R\_NS}$ ist die Breite des rechteckigen Absorbers 2015 in Nord-Süd-Richtung und $B_{R\_OW}$ in Ost-West-Richtung. Für die Dimensionen des Absorber 2015 gilt wie in Fig. 20 dargestellt:

$$B_{R\_NS} = 12,5 \text{ m}, \ B_{R\_OW} = 12,5 \text{ m } (156,25 \text{ m}^2).$$

Für die Höhe des Receivers über dem Heliostatenfeld der Receiverhöhe gilt $H_R$ = 150 m.

**Receiver-Tragstruktur**

Der Receiver ist an eine Tragstruktur hängend montiert, die den Receiver frei über dem Heliostatenfeld hält. Dies kann zum Beispiel ein Bogensystem mit zwei Standfüßen sein, wie in Fig. 14a dargestellt. Der Bogen würde sich von Osten nach Westen über das Heliostatenfeld spannen.

**Heliostaten**

Die Heliostaten 1290 mit FQA sind in Gruppen von je 6 Heliostaten zusammengesetzt, wobei fünf Gruppen von Heliostaten 1283 zu einem Modul 1280 mit einem gemeinsamen Tragsystem, bestehend aus einem Tragrahmen 1285 und Beinen 1287, zusammengesetzt sind, wie in Fig. 12 gezeigt.

$$\text{Reflektorfläche } F_{Hel} = L_{Hel} \text{ x } B_{Hel} = 1,36425 \text{ m}^2 \ .$$

$L_{Hel}$ = 3,21 m (Länge), $B_{Hel}$ = 0,425 m (Breite). Siehe Fig. 13.
Die Zwischenräume $Z_{NS}$ zwischen den sechs Heliostaten 1390 innerhalb einer Gruppen von Heliostaten 1383 betragen 0,05 m, ähnlich wie in Fig. 13 gezeigt. Die Abstände $A_{OW}$ zwischen den fünf Gruppen von Heliostaten 1283 sind innerhalb eines Moduls 1280 gleich. Die Abstände $A_{OW}$ zwischen den Gruppen der Heliostaten 1283 können sich jedoch von einem Modul 1280 zum andern unterscheiden.
Die Heliostaten sind entlang der Länge mit einer Brennweite von 300 m gekrümmt und konzentrierend.

**Heliostatenfeld**

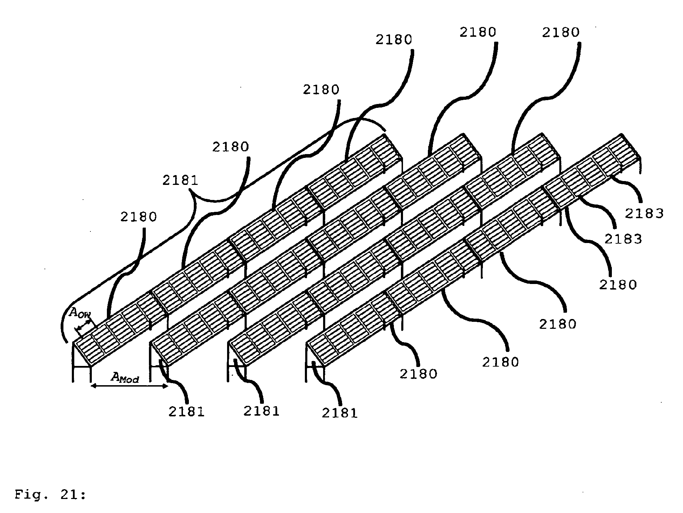

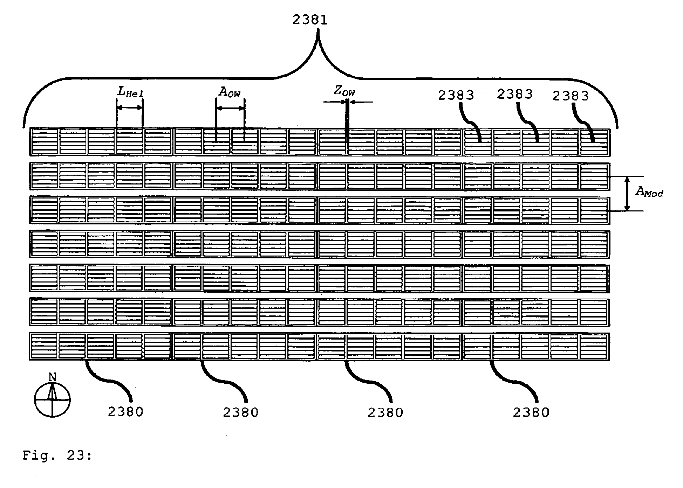

Das Heliostatenfeld besteht aus einer Vielzahl Modulen 1280 von Heliostaten mit FQA mit gekoppelter Nachführung um die erste und zweite Drehachse innerhalb der Gruppen von Heliostaten 1283.
Die Heliostaten mit FQA werden in parallelen Reihen von Modulen 2180 von Heliostaten mit FQA in Ost-West-Richtung aufgestellt, wie in Fig. 21 in einer perspektivischen Darstellung für vier Reihen von je vier Modulen gezeigt. In der in Fig. 21 dargestellten Situation sind die Abstände $A_{OW}$ der Gruppen von Heliostaten 2183 innerhalb der Module 2180 gleichbleibend, ebenso die Abstände der zwischen den Reihen von Modulen 2180 wie auch der Winkel $\alpha$. Dies ist charakteristisch für einen Ausschnitt aus dem Nahfeld. Die Abstände, Winkel und Größen sind nur maßstäblich.
Das Heliostatenfeld besteht aus einem Nahfeld 2236 und einem Fernfeld 2238.
In Fig. 22 ist das beschriebene Heliostatenfeld, bestehend aus einem Nahfeld 2236 und dem Fernfeld 2238, in einer Draufsicht dargestellt, wobei jeder einzelne Punkt die Position Gruppe von Heliostaten 1383, wie in Fig. 13 gezeigt, repräsentiert. Der Nullpunkt des Koordinatensystems ist durch die Position der Mitte des Receivers 2210, der hier durch einen größeren nicht maßstäblichen Punkt repräsentiert wird, definiert. Die äußere Umrandung des Nahfeldes 2237 ist zugleich die Grenze zum Fernfeld. Die äußere Umrandung des Fernfeldes ist zugleich die äußere Umrandung des gesamten Heliostatenfeldes 2239.
Im Nahfeld 2236 sind die Abstände $A_{OW}$ der Gruppen von Heliostaten in Ost-WestRichtung gleichbleibend und mit der maximalen Reflektorflächendichte $\varrho_{max}$ aufgestellt, wie aus dem vergrößerten Ausschnitt der Draufsicht auf das Nahfeld in Fig. 23 besser ersichtlich. Die Reflektorflächendichte $\varrho$ im Nahfeld ist gleich der maximalen Reflektorflächendichte $\varrho_{max}$ im Heliostatenfeld.
Der Nahbereich des Heliostatenfeldes erstreckt sich gemäß Fig. 22 in Ost-West-Richtung von 80 m in östlich des Receivers bis 80 m westlich des Receivers und in Nord-Süd-Richtung von 83 m nördlich des Receivers bis 173 m südlich des Receivers.

In Fig. 23 ist ein Ausschnitt aus der Draufsicht eines Nahfeldes nicht maßstabsgerecht dargestellt. Die Abstände $A_{Mod}$ der Modulreihen in Nord-Süd-Richtung sind gleich im Nahfeld, ebenso die Abstände $A_{OW}$ der Heliostaten innerhalb der Modulreihen in Ost-West-Richtung.

In Ost-West-Richtung sind die Heliostaten im Nahfeld mit Abständen $A_{OW}$ von 3,61 m aufgestellt, d.h. dass es zwischen den Reflektoren mit Länge $L_{Hel}$ von 3,21 m jeweils einen Zwischenraum $Z_{OW}$ von 0,4 m gibt, wenn die Reflektoren wie dargestellt parallel ausgerichtet sind.

Die hohe Aufstelldichte innerhalb der Ost-West-Reihen von ca. 89% (=3,21 m/3,61 m) ist möglich durch die Verwendung von Heliostaten mit FQA und für die freie Bewegung benötigte Raumvolumina der Heliostaten auf Grund von Reflektoren, die in Ost-West-Richtung wesentlich größere Länge $L_{Hel}$ als Breite $B_{HEL}$ haben ($L_{Hel} > 6 \times B_{HEL}$), wie in Fig. 12 gezeigt. Die Verwendung von Heliostaten mit FQA erlaubt sogar eine grundsätzlich höhere Aufstelldichte innerhalb der Ost-West-Reihen, wenn die Installation und Fertigung präzise ist und lokale Sicherheitsstandards erfüllt sind.

In Nord-Süd-Richtung sind die Modulreihen im Nahfeld mit Abständen $A_{Mod}$ von 3,20 m aufgestellt, d.h. dass sich aus $B_{Hel} = 0,425$ m für jeweils sechs Heliostaten pro Gruppe von Heliostaten eine Aufstelldichte in Nord-Südrichtung von 80% (= 6 x 0.425 m/3,20 m) ergibt. Die Aufstelldichte der Reihen kann grundsätzlich auch höher sein, wenn die Installation und Fertigung präzise ist und lokale Sicherheitsstandards erfüllt sind.

Aus der Kombination der Aufstelldichte in Ost-West und in Nord-Süd ergibt sich im Nahfeld eine konstante Reflektorflächendichte von $\varrho_{max} = ca. 71\%$.

Im Fernfeld vergrößern sich die Abstände mit zunehmendem Abstand vom Receiver 2210 sowohl in Ost-West- als auch Nord-Süd-Ausrichtung. Die Abstände der Heliostaten wachsen im Fernfeld in Ost-West-Richtung von 3,61 m auf bis zu 6,39 m und die Abstände der Modulreihen in Nord-Süd-Richtung von 3,20 m auf bis zu 6,63 m.

In Fig. 24 ist ein Ausschnitt der Draufsicht eines Fernfeldes mit Heliostaten mit FQA dargestellt. Die Darstellung der Abstände zeigt nur das Prinzip. Die Abstände sind nicht maßstabsgerecht. Es ist zu erkennen, dass für den dargestellten Fall, bei dem der Receiver 2210 sich südwestlich dieses Feldausschnittes befindet, die Abstände von Westen nach Osten und von Süden nach Norden zunehmen.

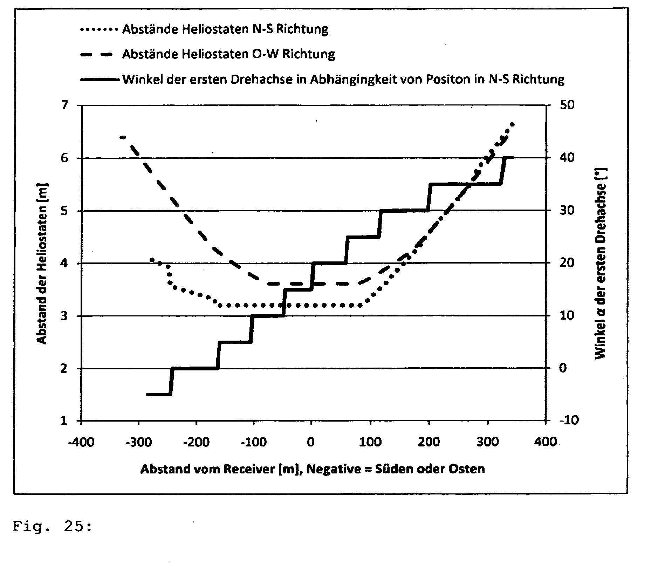

Der Winkel $\alpha$ der Aufstellfläche und ersten Drehachse gegenüber der Gesamtgrundfläche ist maximal bei den Modulreihen am nördlichen Ende des Heliostatenfeldes und nimmt zum Süden hin ab, wie auch in Fig. 25 gezeigt. Es ist zu erkennen, dass der Winkel $\alpha$ sich in 5°-Schritten verändert. Dies geschieht aus produktionstechnischen Erwägungen, rein theoretisch könnte sich der Winkel $\alpha$ auch kontinuierlich verändern. Zudem ist zu erkennen, dass südlich des Receivers der Winkel $\alpha$ auch negativ werden kann, wobei positive Werte bedeuten, dass die Drehachse so gekippt ist, dass das höhere Ende Richtung Erdpol (Norden) zeigt während negative Werte bedeuten, dass das höhere Ende der Drehachse Richtung Äquator (Süden) zeigt.

Das gesamte Heliostatenfeld erstreckt sich in Nord-Süd-Richtung von 340 m nördlich des Receivers 2210 bis 285 m südlich des Receivers 2210 und in Ost-West-Richtung von 330 m östlich des Receivers bis 330 m westlich des Receivers 2210.

Die Reflektorflächendichte für das gesamte Heliostatenfeld $\varrho_{Gesamt}$ beträgt $\varrho_{Gesamt} = 51\%$.

Der Umfang des Heliostatenfeldes beschreibt in Fig. 22 eine Form, die außerhalb eines Kreises und gleichzeitig innerhalb eines Quadrates verläuft. Das Zentrum des Heliostatenfeldes liegt ca. 25 m nördlich des Receivers 2210, wie aus den in Fig. 22 eingezeichneten Maßstabsangaben ersichtlich ist. Der Receiver 2210 ist ca. 25 m aus dem Zentrum des Felds nach Süden verschoben. Der Durchmesser des Heliostatenfeldes ist ca. 700 m und somit ca. 4.5 x $H_R$.

Das Heliostatenfeld ist kontinuierlich durchgehend und lediglich dann nur für die Fußpunkte der Tragestruktur unterbrochen, sollte die technische Umsetzung der Spannweite der Tragstruktur Fußpunkte innerhalb des Heliostatenfeldes notwendig machen.

**Zusammenfassung der wesentlichen Merkmale zu Ausführungsbeispiel 2**

- Receiverhöhe $H_R$: 150 m über Heliostatenfeld.
- Fläche des Absorber des Receivers: 12,5m x 12,5m = 156,25 m$^2$.
- Receiver-Ausrichtung: Normalenvektor der Absorberfläche des Receivers 2210 senkrecht nach unten gerichtet, wie in Fig. 20 dargestellt.
- Tragstruktur: Bogensystem, wie in Fig. 14a, Ost-West über Heliostatenfeld bestehend aus Nahfeld 2236 und Fernfeld 2238 gespannt.

- Heliostatenfeld mit konstanter Reflektorflächendichte $\varrho$ im Nahfeld 2236 die gleich der maximalen Reflektorflächendichte $\varrho_{max}$ von ca. 71%.

   1. Heliostaten mit fester Quasipolarachsen-Aufhängung für hohe Reflektorflächendichte.

   2. Heliostatenfeld im Nahbereich Reflektorflächendichte $\varrho = \varrho_{max} = 71\% > 60\%$.

   3. Heliostatenfeld, das sich in Nord-,Ost-, Süd- und West-Richtung um den Receiver erstreckt und eine kontinuierlich durchgehende (ununterbrochene) Fläche darstellt.

- Im Fernfeld zunehmende Abstände zwischen den Modulreihen der Heliostaten in Nord-Süd-Richtung und der Heliostaten in Ost-West-Richtung.
- Reflektorflächendichte für das gesamte Heliostatenfeld $\varrho_{Gesamt}$ beträgt $\varrho_{Gesamt} = 51\%$.
- Heliostaten mit fester Quasipolarachsen-Aufhängung für hohe Reflektorflächendichte.
- Abmessungen des Nahfeldes 2236: 83 m östlich bis 83 m westlich vom Receiver und 80 m nördlich des Receivers und 173 m südlich des Receivers 2210.
- Im Fernfeld 2238 zunehmende Abstände zwischen den Heliostaten in Ost-West und zwischen den Modulreihen in Nord-Süd-Richtung.

### Ausführungsbeispiel 3

Eine weitere beispielhafte Auslegung für ein kleines solares Zentralreceiversystem auf Basis dieser Patentschrift unter der Verwendung von Heliostaten mit fester Horizontalachsen-Aufhängung in einem Heliostatenfeld, welches ausschließlich aus einem Nahfeld besteht und bei dem die Tragstruktur ein Turmdrehkran mit Ausleger ist, der die Bewegung des Receivers in bis zu drei Dimensionen ermöglicht:

### Annahmen für Auslegung des solaren Zentralreceiversystems

Auslegungszeitpunkt: 21. Juni, 12 Uhr mittags, Sonnenzeit.
Standort: Breitengrad 34° N, nördlicher Breitengrad, (z.B. Nordafrika oder Südkalifornien, USA).
Annahme: Direkt-Normal-Strahlung (solare Strahlungsleistung) zum Auslegungszeitpunkt: 1000 W/m$^2$.
Strahlungsleistung (thermische Leistung in Megawatt - MW$_{th}$) auf der Zielfläche des Receivers zum Auslegungspunkt: 2 MW$_{th}$.

### Receiver

Der verwendete Receiver ist ein Hohlraumreceiver, wie in Fig. 15 dargestellt. Der Normalenvektor $n_R$ der Aperturfläche zeigt nach unten. $B_{R\_NS}$ ist die Breite der rechteckigen Apertur 1511 in Nord-Süd-Richtung und $B_{R\_OW}$ in Ost-West-Richtung. Für die Dimensionen der Apertur 1511 des Hohlraumreceivers gilt wie in Fig. 15 dargestellt:

$$B_{R\_NS} = 3 \text{ m}, \quad B_{R\_OW} = 6 \text{ m} \quad (18 \text{ m}^2)$$

Für die Höhe des Receivers über dem Heliostatenfeld der Receiverhöhe gilt $H_R = 45$ m.
Receiverhöhe über Heliostatenfeld: $H_R = 45$ m.

### Receiver-Tragstruktur

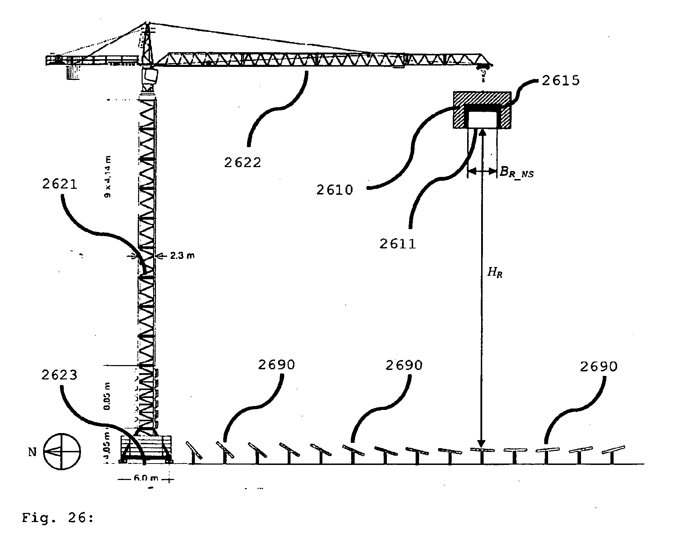

Die Tragstruktur ist, wie in Fig. 26 dargestellt, ein Turmdrehkran bestehend aus einer vertikalen Tragstruktur 2621 und einem Ausleger 2622 an den ein Receiver 2610 hängend über dem Heliostatenfeld montiert ist. Der Fußpunkt 2623 der vertikalen Tragstruktur 2621 des Turmdrehkrans ist nördlich des Heliostatenfeldes.
Wie in Fig. 27 zu erkennen, kann der Ausleger 2722 um eine vertikale Drehachse in der vertikalen Tragstruktur 2721 gedreht werden. Zudem kann der Receiver 2710 entlang des Auslegers 2722 vor und zurück bewegt werden. Dadurch kann die Position des Receiver 2710 je nach Stand der Sonne verändert werden und somit der Wirkungsgrad des Heliostatenfeldes optimiert werden. Es ist zu erkennen, dass der Receiver 2710 in den beiden dargestellten Auslegerpositionen sich ebenfalls in verschiedenen Positionen entlang des Auslegers 2722 befindet. Die Position, in der sich der Receiver 2710 über dem Nullpunkt des Heliostatenfeldes befindet, ist die Situation bei der die Sonne sich mittags genau südlich vom Heliostatenfeld befindet, während die andere Position die Situation darstellt, wenn sich die Sonne im Sommer morgens nord-östlich vom Heliostatenfeld befindet.

Grundsätzlich ist es auch möglich, dass die Position des Receivers 2710 in der Höhe $H_R$ verändert werden kann.

**Heliostaten**

Heliostaten mit fester Horizontalachsen-Aufhängung (FHA)
Reflektorfläche $F_{Hel} = L_{Hel}$ x $B_{Hel} = 7,2225$ m$^2$
$L_{Hel} = 3,21$ m (Länge), $B_{Hel} = 2,25$ m (Breite)

Die Reflektoren der Heliostaten sind entlang der Länge mit einer Brennweite von 49,5 m gekrümmt und konzentrierend.

**Heliostatenfeld**

Die Heliostaten werden in parallelen Reihen in Ost-West-Richtung aufgestellt, wobei die Heliostaten auch in Nord-Süd-Richtung in Reihen stehen. Siehe Fig. 27. In anderen Auslegungen können die Heliostaten benachbarter Ost-West-Reihen auch um einen halben Heliostatenabstand $A_{OW}$ (vgl. Fig. 17) zueinander versetzt stehen, wie in Fig. 10.

Das Heliostatenfeld besteht aus Nahfeld und keinem Fernfeld.

In Fig. 27 ist das beschriebene Heliostatenfeld, bestehend aus einem Nahfeld und keinem Fernfeld, in einer Draufsicht dargestellt, wobei jeder einzelne Punkt die Position eines einzelnen Heliostaten in Nord-Süd-Richtung und Ost-West-Richtung repräsentiert. Der Nullpunkt des Koordinatensystems ist durch die Position der Mitte des Receivers 2710, der hier durch einen größeren nicht maßstäblichen Punkt repräsentiert wird, definiert.

Die Heliostaten 2790 sind im gesamten Heliostatenfeld in gleichbleibenden Abständen zueinander mit der maximalen Reflektorflächendichte $\varrho_{max}$ aufgestellt, wie aus der Draufsicht in Fig. 27 ersichtlich. Die Reflektorflächendichte $\varrho$ des gesamten Heliostatenfeldes ist somit gleich der maximalen Reflektorflächendichte $\varrho_{max}$ im Heliostatenfeld.

In Ost-West-Richtung sind die Heliostaten im Heliostatenfeld mit Abständen $A_{OW}$ von 2,75 m aufgestellt, d.h. dass es zwischen den Reflektoren mit Breite $B_{Hel}$ von 2,25 m jeweils einen Zwischenraum $Z_{OW}$ von 0,5 m gibt, wenn diese sich in horizontaler Parkposition befinden, bei der die Reflektoren horizontal sind und die lange Seite der Heliostaten in Nord-Süd-Richtung orientiert sind, wie in der Draufsicht in Fig. 17 dargestellt.

Die hohe Aufstelldichte innerhalb der Ost-West-Reihen von ca. 82% (=2,25 m/2,75 m) ist möglich durch die Verwendung von Heliostaten mit fester Horizontalachsen-Aufhängung (FHA), wie in WO 02/070966 A1, WO 2008/092194 A1 und WO 2008/092195 A1 be-schrieben.

In Nord-Süd-Richtung sind die Heliostatenreihen im Nahfeld mit Abständen $A_{NS}$ von 4,21 m aufgestellt, d.h. dass es zwischen den Reflektoren mit der Länge $L_{Hel} = 3,21$ m (und somit 3,21 m breiten Reihen) jeweils einen Zwischenraum $Z_{NS}$ von 1,0 m gibt, wenn diese sich in horizontaler Parkposition befinden. Siehe Fig. 17. Die Aufstelldichte der Reihen kann grundsätzlich auch höher sein, wenn die Heliostatenreihen um jeweils einen halben Heliostatenabstand $A_{OW}$ (vgl. Fig. 17) versetzt sind, wie in Fig. 10 dargestellt.

Aus der Kombination der Aufstelldichte in Ost-West und in Nord-Süd ergibt sich im Heliostatenfeld eine konstante Reflektorflächendichte von $\varrho_{max} = \mathtt{ca.}$ 62%

Im Gegensatz zum Auslegungsbeispiel 1 besteht dieses Heliostatenfeld ausschließlich aus einem Nahfeld mit Heliostaten in gleichbleibenden Abständen zueinander.

Das gesamte Heliostatenfeld erstreckt sich in Nord-Süd-Richtung von ca. 38 m nördlich des Receivers 2710 bis zu 17 m südlich des Receivers 2710 und in Ost-West-Richtung von 33 m östlich des Receivers bis 33 m westlich des Receivers 2710.

Der Umfang des Heliostatenfeldes beschreibt in Fig. 27 in etwa eine Kreisform. Das Zentrum des Heliostatenfeldes liegt ca. 10 m nördlich des Receivers 2710, wie aus in Fig. 27 eingezeichneten Maßstabsangaben ersichtlich ist. Der Receiver 2710 ist ca. 10 m aus dem Zentrum des Felds nach Süden verschoben. Der Durchmesser des Heliostatenfeldes ist ca. 60 m und somit ca. 1,3 x $H_R$.

Das Heliostatenfeld ist kontinuierlich durchgehend.

**Zusammenfassung der wesentlichen Merkmale zu Ausführungsbeispiel 3**

- Receiverhöhe $H_R$: 45 m über Heliostatenfeld.
- Fläche der Receiver-Apertur: 3 m x 6 m = 18 m$^2$.

Receiver-Ausrichtung: Normalenvektor der Aperturfläche des Receivers 2710 senkrecht nach unten gerichtet, wie in Fig. 15 und Fig. 26 dargestellt.

- Tragstruktur: Turmdrehkran, bestehend aus einer vertikalen Tragstruktur 2621 und einem Ausleger 2622 für hängend montierten Receiver 2610 und mit Fußpunkt nördlich vom Heliostatenfeld.
- Heliostatenfeld mit konstanter Reflektorflächendichte $\varrho$ entspricht der maximalen Reflektorflächendichte $\varrho_{max}$ von ca. 71%.

   1. Heliostaten mit fester Horizontalachsen-Aufhängung für hohe Aufstelldichte innerhalb einer Reihe in Ost-West-Richtung.

   2. Heliostatenfeld mit Reflektorflächendichte $\varrho = \varrho_{max} = \varrho_{Gesamt} = 68\% > 60\%$.

   3. Heliostatenfeld, das sich in Nord-,Ost-, Süd- und West-Richtung um den Receiver erstreckt und eine kontinuierlich durchgehende (ununterbrochene) Fläche darstellt.

- Kein Fernfeld.
- Reflektorflächendichte für das gesamte Heliostatenfeld $\varrho_{Gesamt}$ beträgt $\varrho_{Gesamt} = \varrho = \varrho_{max} = 68\%$.

**Vorgehensweise für die Auslegung der Ausführungsbeispiele 1 bis 3**

Für Auslegung der vorhergehenden Ausführungsbeispiele 1 bis 3 ist folgende Vorgehensweise in vier vorzugsweise aufeinander folgenden Schritten gewählt worden:

Verfahren zur Auslegung eines Heliostatenfeldes eines solaren Zentralreceiversystems,

a) wobei im ersten Schritt eine Aufstellung der Heliostaten (1790; 1290, 1390) für ein Nahfeld (1636; 2236) auf einer vorzugsweise ebenen Gesamtgrundfläche definiert wird, das eine Reflektorflächendichte ρ von ρ > 60% aufweist,

- wobei die Reflektorflächendichte ρ als Verhältnis aus der gesamten Reflektorfläche einer Region des Heliostatenfeldes zur überbauten Grundfläche derselben Region des Heliostatenfeldes definiert ist,
- wobei jeder Heliostat einen um zwei Drehachsen (792, 793; 992, 993) verstellbaren Reflektor (795; 995) aufweist, der die solare Strahlung auf die Zielfläche eines oder mehrerer Receiver (1610; 2210) bei sich ändernden Sonnenstand reflektiert,
- wobei die Zielfläche eine Apertur (1511; 2011) bzw. ein thermischer Absorber (2015) bzw. ein photovoltaischer Absorber (2015) des jeweiligen Receivers ist (Fig. 15; Fig. 20),
- wobei bei jedem Heliostaten die erste Drehachse (992; 1292, 1392) parallel zu der Aufstellfläche ausgebildet ist (Fig. 9; Fig. 12, Fig. 13) und eine Gruppe von Heliostaten mit einer gemeinsamen Aufstellfläche in einer Reihe aufgestellt sind, so dass die erste Drehachse (992; 1292, 1392; 1792) der Heliostaten (1290, 1390; 1790) in der jeweiligen Gruppe auf einer Linie liegen, d.h. miteinander fluchten,
- wobei der Reflektor (995; 1295, 1395; 1795)jedes Heliostaten rechteckförmig ausgebildet ist und in Richtung der zweiten Drehachse (993; 1293, 1393) bevorzugt länger ist als in die dazu senkrechten Richtung und

b) wobei die gemeinsame Aufstellfläche einer oder mehrerer Gruppen von Heliostaten (1283; 1383) zur Gesamtgrundfläche jeweils um einen von der Position zum Receiver abhängigen Winkel $\alpha$ (Fig. 12) geneigt sein kann,

- wobei im zweiten Schritt die Positionen der Heliostaten mit dem Abstand vom Receiver (1610; 2210) bestimmt werden, wobei berechnet wird, wie weit das Nahfeld (1636; 2236) mit gleicher Reflektorflächendichte ρ um den Receiver herum reicht und
- wo das Fernfeld (1638; 2238)anschließend an das Nahfeld beginnt,
- wobei im Fernfeld die Abstände in Ost-West-Richtung bzw. Nord-Süd-Richtung vergrößert werden müssen, um das gegenseitige Blockieren der Heliostaten weitgehend zu vermeiden bzw. gering zu halten,
- wobei Blockieren bedeutet, dass ein Heliostat den Strahlengang vom Reflektor eines benachbarten Heliostaten zur Zielfläche des Receivers mindestens teilweise abdeckt,

c) wobei im dritten Schritt die Strahlungsleistung, die die jeweiligen Heliostaten auf die Zielfläche des Receivers (1610; 2210) transferieren, berechnet wird und bevorzugt diejenigen Heliostaten für das Heliostatenfeld ausgewählt werden, die zum Auslegungszeitpunkt oder anderen bestimmten Zeitpunkten oder Zeiträumen den höchsten Beitrag zur Strahlungsleistung auf der Zielfläche des Receivers leisten,

- wobei das Heliostatenfeld mindestens aus einem Nahfeld und, je nach erforderlicher Strahlungsleistung auf der Zielfläche des Receivers, auch aus einem Fernfeld gebildet wird,
- wobei, sofern eine Receiverhöhe $H_R$ von mindestens 100 m gewählt wird, ein Fernfeld vorgesehen wird und der größte Durchmesser $D_H$ des Heliostatenfeldes verzugsweise weniger als das Sechsfache der Receiverhöhe $H_R$ beträgt,
- wobei im vierten Schritt eine Tragstruktur (Fig. 14) ausgewählt wird, die geeignet ist, den Receiver (1410) in der definierten Position über dem Heliostatenfeld zu halten, wobei diese Tragstruktur ausgebildet ist als

  i. ein Bogen (Fig. 14a),
  ii. oder ein Sprengwerk (Fig. 14b)
  iii. oder eine abgehängte Seilkonstruktion (Fig. 14c),

  - wobei diese drei Tragstrukturen, i, ii und iii, mit jeweils mindestens zwei Fußpunkten, die sich bevorzugt im Außenbereich oder außerhalb des Heliostatenfeldes befinden,

  iv. oder ein kranförmiges Tragwerk (Fig. 14d) mit einem den Receiver (1410) tragenden Ausleger bzw. Kragarm(1422), der sich über das Heliostatenfeld erstreckt,

  - wobei ein oder mehrere Fußpunkte des kranförmigen Tragwerks sich entweder im Außenbereich oder bevorzugt außerhalb des Heliostatenfeldes auf der vom Äquator abgewandten Seite des Receivers befinden,
  - wobei die Position eines am Ausleger (2622, 2722) montierten Receivers (2610, 2710) in bis zu drei Dimensionen veränderbar sein kann,
  - so dass für das im dritten Schritt bestimmte Heliostatenfeld verschiedene Positionen für den Receiver für bestimmte Sonnenstände gewählt werden, um den Wirkungsgrad des Heliostatenfeldes für die jeweiligen Sonnenstände zu erhöhen (Fig. 26, Fig. 27).

In der Anmeldung werden die folgenden Definitionen verwendet.

**Definitionen:**

Heliostat mit fester Quasipolarachsen-Aufhängung (FQA): Ein Heliostat mit FQA ist ein Heliostate bei dem die erste feste Drehachse parallel ist zu einer Aufstellfläche die wiederum um einen Winkel $\alpha$ zur Gesamtgrundfläche gekippt ist.

Gruppe von Heliostaten: Ist eine Vielzahl von Heliostaten mit FQA die eine gemeinsame Aufstellfläche und eine gemeinsame erste Drehachse die beide einen Winkel $\alpha$ zur Gesamtgrundfläche haben.

Modul: Eine Mehrzahl von Gruppen von Heliostaten die alle eine gemeinsame Aufstellfläche und parallele erste Drehachsen haben sind zu einem Modul zusammengefasst und werden von einem gemeinsamen Tragsystem aus Tragrahmen und Beinen gehalten. Aufstellfläche: Die Aufstellfläche eines Heliostaten ist eine frei definierte Bezugsfläche zu der die erste Drehachse des Heliostaten fest angeordnet ist.

Erste Drehachse: Die erste Drehachse ist eine der zwei Drehachsen des Heliostaten, wobei die erste Drehachse in Bezug auf die Aufstellfläche ist.

Zweite Drehachse: Die zweite Drehachse ist eine der zwei Drehachsen des Heliostaten, wobei die zweite Drehachse in Bezug auf den Reflektor fest angeordnet ist.

Normalenvektor des Receivers: Der Normalenvektor $n_R$ des Receivers ist der Flächennormalenvektor der Zielfläche des Receivers.

Receiverbreite: Die Receiverbreite ist die Breite der Zielfläche des Receivers bzw. die Seitenlänge der Zielfläche im Falle einer rechteckigen Zielfläche.

Verschatten: Wenn Heliostaten sich im Heliostatenfeld verschatten, dann bedeutet das, dass ein Heliostat den Strahlengang von der Sonne auf den Reflektor eines benachbarten Heliostaten mindestens teilweise abdeckt.

Blockieren: Wenn Heliostaten sich im Heliostatenfeld blockieren, dann bedeutet das, dass ein Heliostat den Strahlengang vom Reflektor eines benachbarten Heliostaten zur Zielfläche auf dem Receiver mindestens teilweise abdeckt.

Auslegungszeitpunkt: Der Auslegungszeitpunkt ist der Zeitpunkt zu dem ein solares Zentralreceiverkraftwerk ausgelegt ist und die Leistungen des Systems, wie auch die Strahlungsleistung auf der Zielfläche des Receivers, definiert sind. Typischer Weise ist der Auslegungszeitpunkt am Tag der Sommersonnenwende (21. Juni auf der nördlichen Erdhemisphäre) um 12 Uhr mittags, Sonnenzeit.

Heliostat: Ein Heliostat ist ein um zwei Achsen verstellbarer Reflektor, der die solare Strahlung auf einen Zielpunkt oder Zielfläche reflektiert. Die zweiachsige Nachführung sorgt dafür, dass der Zielpunkt oder die Zielfläche kontinuierlich bei einem sich über den Tag verändernden Sonnenstand bestrahlt werden, wobei der Heliostat eine erste Drehachse und eine zur ersten senkrecht angeordnete zweite Drehachse hat, die auf einer Aufstellfläche angeordnet ist, wobei die erste Drehachse in Bezug auf die Aufstellfläche und die zweite Drehachse in Bezug auf den Reflektor fest angeordnet sind. Der Reflektor der vorliegenden Erfindung hat eine rechteckige Form, wobei die kürzere Kantenlänge als Breite $B_{Hel}$ und die längere Kantenlänge als Länge $\underline{L_{Hel}}$ bezeichnet wird. Somit hat der rechteckige Reflektor die Reflektorfläche $F_{Hel} = B_{Hel} \times \underline{L_{Hel}}$.

Heliostaten mit fester Horizontalachsen-Aufhängung: Ein Heliostat mit fester Horizontalachsen-Aufhängung ist ein Heliostat mit zwei senkrecht zueinander angeordneten Achsen, wobei die erste Achse horizontal und feststehend angeordnet ist, um die sich die zweite Achse bewegt. Bei der vorliegenden Erfindung wird eine Heliostat mit einer solchen Horizontalachsen-Aufhängung verwendet, wie sie ausführlich in WO 2008/092194 A1, WO 2008/092195 A1 sowie in WO 02/070966 A1 und in [8] beschrieben ist.

Heliostatenfeld: Ein Heliostatenfeld ist ein aus einer Vielzahl von Heliostaten gebildetes Feld, das die solare Strahlung auf einen Zielpunkt oder eine Zielfläche eines Receivers reflektiert, dessen Prinzip beispielsweise aus der US Patentschrift US 4 172 443 bzw. US 4 220 140 bekannt, siehe auch die daraus entnommenen Fig. 1 bzw. Fig. 5.

Receiver: Ein Receiver ist ein System, welches solare Strahlung in Wärme oder wenn es sich um einen Photovoltaik-Receiver handelt direkt in elektrischen Strom umwandelt. Die Wärme aus einem thermischen Receivers wird einem Wärmeträgermedium zugeführt, welches u.a. Wasser, Wasserdampf oder Luft sein kann. Der Receiver befindet sich typischer Weise im Zielpunkt des Heliostatenfeldes. Das Prinzip eines Receivers wird beispielsweise aus der US Patentschrift US 4 172 443 bzw. US 4 220 140 bekannt, siehe auch die daraus entnommenen Fig. 1 bzw. Fig. 5.

Hohlraumreceiver: Wie in Fig. 15a dargestellt, ist ein Hohlraumreceiver ein Receiver, bei dem die die solare Strahlung absorbierende Fläche, der Absorber 1515, innerhalb eines Hohlraumes 1512 liegt. Die Strahlung gelingt durch die Apertur 1511 in den Hohlraum. Das Prinzip eines solchen Hohlraumreceivers ist beispielsweise aus der Patentschrift US 4 220 140 bzw. WO 2008/153922 A1 sowie aus [9] bekannt.

Absorber: Der Absorber ist der Teil des Receivers, auf den die solare Strahlung trifft und diese im Falle eines thermischen Absorbers in Wärme wandelt und an ein Wärmeträgermedium abgeführt, wie beispielsweise aus der US Patentschrift US 4 220 140 bekannt oder im Falle eines photovoltaischen Absorbers aus Photovoltaikzellen besteht die die solare Strahlung direkt in elektrischen Strom wandeln.

Receiver mit externen Absorber: Ein Receiver mit externem Absorber ist ein Receiver, bei dem die absorbierende Fläche Teil der äußeren Oberfläche des Receivers ist, beispielsweise die Mantelfläche eines zylindrischen Receivers, wie aus der US Patentschrift US 4 172 443 bekannt, aus der die Fig. 1 herausgenommen worden ist, die die zylindrischen Mantelfläche des Receivers 110 zeigt, oder in Fig. 15b und Fig. 20b bei dem der Absorber 1515/2015 sich auf einer Außenseite des Receivers befindet.

Apertur: Die Apertur ist die optische Eintrittsöffnung eines Hohlraumreceivers, wie beispielsweise aus [9] der WO 2008/153922 A1 bekannt und in Fig. 15 zu sehen.

Zielfläche: Je nach Art des Receivers kann die Apertur, der thermische Absorber oder der photovoltaische Absorber die Zielfläch des Receivers sein.

Nahfeld: Das Nahfeld eines Heliostatenfeldes wird bei der vorliegenden Erfindung als der Teil des Heliostatenfeldes definiert, der sich unterhalb des Receivers erstreckt und eine konstante Reflektorflächendichte $\varrho$ aufweist. Das heißt, dass die Heliostaten in gleichbleibenden Abständen zueinander aufgestellt sind. Ein Heliostatenfeld kann auch ausschließlich aus einem Nahfeld bestehen.

Fernfeld: Das Fernfeld eines Heliostatenfeldes wird als der Teil des Heliostatenfeldes definiert, der den Receiver mit einem gewissen horizontalen Abstand ganz oder teilweise umgibt und bei dem die Reflektorflächendichte $\varrho$ mit größer werdendem horizontalen Abstand vom Receiver abnimmt. Ein Heliostatenfeld kann auch ausschließlich aus einem Fernfeld bestehen.

Reflektorfläche: Die Reflektorfläche ist die Fläche $F_{Hel}$ des Reflektors eines einzelnen Heliostaten.

Reflektorflächendichte $\varrho$ : Die Reflektorflächendichte $\varrho$ ist das Verhältnis der Reflektorfläche einer Region des Heliostatenfeldes zur Grundfläche dieser Region des Heliostatenfeldes.

Maximale Reflektorflächendichte $\varrho_{max}$ : Die maximale Reflektorflächendichte $\varrho_{max}$ entspricht dem höchsten Wert der im gesamten Heliostatenfeld vorkommenden Reflektorflächendichte.

Gesamte Reflektorflächendichte $\varrho_{Gesamt}$ : Die gesamte Reflektorflächendichte $\varrho_{Gesamt}$ ist das Verhältnis der Reflektorfläche des gesamten Heliostatenfeldes zur Grundfläche des gesamten Heliostatenfeldes.

Heliostatenbreite: Die Heliostatenbreite ist die Breite $B_{Hel}$ des rechteckigen Reflektors des Heliostaten und ist bei der vorliegenden Erfindung, wie in Fig. 17 gezeigt, immer kleiner als die Länge $L_{Hel}$ des Reflektors.

Heliostatenlänge: Die Heliostatenlänge entspricht der Länge $L_{Hel}$ des rechteckigen Reflektors des Heliostaten und ist bei der hier beschriebenen Erfindung, wie in Fig. 17 gezeigt, immer größer oder gleich der Breite $B_{Hel}$ des Reflektors.

Heliostatenreihen: Reihe von Heliostaten, wobei die Heliostaten wie in Fig. 17 dargestellt in einer Linie mit der ersten Drehachse, der festen horizontalen Achse 1792 der Heliostaten mit fester Horizontalachsen-Aufhängung, aufgestellt sind.

Aufstelldichte innerhalb einer Heliostatenreihe: Die Aufstelldichte innerhalb einer Heliostatenreihe ist das Verhältnis der Breite $B_{Hel}$ des Reflektors der Heliostaten zu dem Abstand $A_{OW}$ zweier benachbarter Heliostaten innerhalbe einer Reihe. Hierbei ist der Abstand $A_{OW}$ zweier benachbarter Heliostaten als der Abstand der Mittelpunkte zweier benachbarter Reflektoren dieser Heliostaten definiert, wie in Fig. 17 gezeigt.

Aufstelldichte von Heliostatenreihen: Die Aufstelldichte von Heliostatenreihen ist, wie in Fig. 17 gezeigt, das Verhältnis der Breite der Heliostatenreihe, die gleich der Länge $L_{Hel}$ der Reflektoren der Heliostaten ist, zu dem Abstand $A_{NS}$ zweier benachbarter Heliostatenreihen, wobei der Abstand zweier benachbarter Heliostatenreihen als der Abstand der Mittelpunkte der beiden benachbarten Heliostatenreihen definiert ist.

Durchmesser eines Heliostatenfeldes $D_H$: Der Durchmesser $D_H$ eines Heliostatenfeldes wird, wie in den Fig. 2, 3, 4 und 6 gezeigt, definiert als der Abstand, der am weitesten voneinander entfernten Heliostaten.

Receiverhöhe $H_R$: Die Receiverhöhe $H_R$ ist, wie in Fig. 1 gezeigt, definiert als vertikaler Abstand des Mittelpunktes der Absorber-Fläche eines Receivers mit externem Absorber oder der Receiver-Apertur eines Hohlraumreceivers von der Ebene, die durch die Mittelpunkte der Reflektoren der Heliostaten des Heliostatenfeldes definiert ist. Die Receiverhöhe wird als eine Einheitsgröße verwendet, an der andere Größen, wie z.B. die Heliostatenfeld-Größe, bemessen werden.

**Referenzen**

[1] Winter, C.-J.; Sizmann, R. L.; Vant-Hull, L. L.: Solar Power Plants, Berlin, Heidelberg, New York: Springer, 1991

[2] Burgalet, J-I; Arias, S; Salbidegoitia I.B., Operative advantage of a central tower solar plant with thermal storage system. in SolarPACES 2009, Conference Proceedings, 1.-18. September 2009, Berlin, Deutschland, ISBN 978-3-00-028755-8

[3] Gould, B.: Molten Salt Power Towers, Presentation at DOE Program Review, Austin, Texas 23 April 2008

[4] Koll, G.; Schwarzbözl, P.; Hennecke, K.; Hartz, T.; Schmitz, M.; Hoffschmidt, B.; The solar tower Jülich - A research and demonstration plant for central Receiver systems. in SolarPACES 2009 Conference Proceedings, ISBN 978-3-00-028755-8

[5] Abengoa Solar S.A., White Paper on Solar Tower Technologies, Solutions to Global Climate Change, Heruntergeladen am 19.8.2010 von www.abengoasolar.com seitens Abengoa Solar S.A. mit Sitz in Avda de la Buhaira 2, 48018 Sevilla, Spanien

[6] www.esolar.com seitens eSolar Inc. mit Sitz in 130 West Union Street, Pasadena, CA 91103, USA

[7] Steve Schell, Design and evaluation of eSolar's Heliostat field, in SolarPACES 2009 Conference Proceedings, 1.-18. September 2009, Berlin, Deutschland, ISBN 978-3-00-028755-8

[8] Schramek, P. und Mills, D.R.; Heliostat for maximum ground coverage; Energy 29; 2004; 701-713

[9] Buck, R.; Bräuning, T.; Denk, T.; Pfänder, M.; Schwarzbözl, P.; Téllez, F; Solar-Hybrid Gas Turbine-based Power Tower Systems (REFOS); Journal of Solar Energy Engineering, Vol. 124, February 2002; pp. 2-9

[10] Liebherr, Datenblatt Turmdrehkran 132 EC-H8 FR.tronic, 132 EC-H8 Litronic. Liebherr-Werk Biberach GmbH, Biberach an der Riss. www.liebherr.com

Bezugszeichenliste:

In den Zeichnungen werden in den Figuren die gleichen Bezugszeichen für denselben Sachverhalt verwendet, wobei wenn die beiden letzten Endziffern der Bezugsziffern gleich sind, werden ähnliche Sachverhalte dargestellt, die im Folgenden nur die letzten beiden Endziffern aufgelistet sind. Die vor den beiden Endziffern stehenden Ziffern, bezeichnen die Nummer der jeweiligen Figur.

10   Receiver
11   Apertur
12   Hohlraum
13   Glaskuppel
15   Absorber
17   Einlass des Wärmeträgermediums

18   Auslass des Wärmeträgermediums

20   Tragstruktur
21   vertikale Tragstruktur/Turm
22   Ausleger oder Kragarm
23   Fußpunkt
24   Abspannseil

30   Heliostatenfeld
31   Nordfeld
32   Südfeld
34   Heliostatenfeldaussparung
36   Nahfeld
37   Äußere Grenze des Nahfeldes
38   Fernfeld
39   Äußere Grenze des gesamten Heliostatenfeldes

80   Modul eines FQA Heliostaten
83   Gruppe von Heliostaten
85   Rahmen
87   Beine

90   Heliostat
91   Tragrahmen
92   Erste mit Aufstellfläche fest verbundene Drehachse
93   Zweiter mit Reflektor fest verbundene Drehachse
94   Mechanische Koppelung der Nachführung der zweiten Drehachse
95   Reflektor
99   Raumvolumen in dem der Reflektor sich frei bewegen kann

## Patentansprüche

**1.** Solares Zentralreceiversystem mit einem Heliostatenfeld, bestehend aus

a) einem oder mehreren Receivern (110),
b) einer Vielzahl von das Heliostatenfeld (130) bildenden Heliostaten (190), die auf einer vorzugsweise ebenen Gesamtgrundfläche angeordnet sind, wobei jeder Heliostat einen um zwei Drehachsen (792, 793; 992, 993) verstellbaren Reflektor (795; 995) aufweist, der die solare Strahlung auf die Zielfläche des einen oder der mehreren Receiver bei sich änderndem Sonnenstand reflektiert,
wobei die Zielfläche als eine Apertur (1511; 2011) bzw. ein thermischer Absorber (2015) bzw. ein photovoltaischer Absorber (2015) des jeweiligen Receivers ausgebildet ist,
wobei jeder Heliostat eine erste Drehachse und eine zur ersten Drehachse senkrechte zweite Drehachse hat und auf einer Aufstellfläche angeordnet ist,
wobei die erste Drehachse (792; 992) in Bezug auf die Aufstellfläche und die zweite Drehachse (793; 993) in Bezug auf den Reflektor (795; 995) fest angeordnet sind, und
c) einer Tragestruktur (120), an der der eine oder die mehreren Receiver (110) oberhalb des Heliostatenfeldes (130) befestigt sind,
d) wobei das Heliostatenfeld mit parallelen Reihen von Heliostaten gebildet ist,
e) wobei bei jedem Heliostaten die erste Drehachse (992; 1292; 1392) parallel zu der Aufstellfläche ausgebildet ist,
f) wobei Heliostaten mit einer gemeinsamen Aufstellfläche in einer Reihe aufgestellt sind, so dass die erste Drehachse (1292, 1392; 1792) der Heliostaten in der jeweiligen Gruppe auf einer Linie liegen, d.h. miteinander fluchten,
g) wobei jeder Reflektor 995; 1295; 1395; 1795) rechteckförmig ausgebildet ist,
**dadurch gekennzeichnet,**
h) **dass** die Tragestruktur für den Receiver als eine über das Heliostatenfeld erstreckende Tragestruktur ausgebildet ist,

i) **dass** der Normalenvektor der Zielfläche des Receivers nach unten, vorzugsweise senkrecht, auf das Heliostatenfeld gerichtet ist, und

j) **dass** das Heliostatenfeld unterhalb des Receivers ein Nahfeld (1636; 2236) aufweist, das eine Reflektorflächendichte p von p > 60% aufweist, wobei die Reflektorflächendichte p als Verhältnis aus der gesamten Reflektorfläche einer Region des Heliostatenfeldes zur überbauten Grundfläche derselben Region des Heliostatenfeldes definiert ist, und wobei der Reflektor in Richtung der zweiten Drehachse (993; 1293, 1393) bevorzugt länger ausgebildet ist als in die dazu senkrechte Richtung.

2. Solares Zentralreceiversystem nach Anspruch 1, **dadurch gekennzeichnet, dass** im Nahfeld (1636; 2236) die Abstände benachbarter Heliostaten innerhalb jeder Reihe jeweils einen vorgegebenen ersten Abstand und die Abstände benachbarter Reihen in der dazu senkrechten Richtung einen vorgegebenen zweiten Abstand zueinander aufweisen.

3. Solares Zentralreceiversystem nach Anspruch 1 oder 2, **dadurch gekennzeichnet, dass** die Reihen des Heliostatenfeldes in Ost-West-Richtung oder dass die Reihen des Heliostatenfeldes in Nord-Süd-Richtung ausgerichtet sind.

4. Solares Zentralreceiversystem nach Anspruch 1, **dadurch gekennzeichnet, dass** die gemeinsame Aufstellfläche einer oder mehrerer Gruppen von Heliostaten (1283; 1383) zur Gesamtgrundfläche jeweils um einen von der Position zum Receiver abhängigen Winkel α geneigt ist, wobei eine Anzahl von Gruppen von Heliostaten mit gemeinsamer Aufstellfläche und mit parallelen ersten Drehachsen in einer Reihe senkrecht zur ersten Drehachse jeweils zu einem Modul (1280, 2180, 2380, 2480) und mehrere Module zu einer Modulreihe (2181, 2381; 2481) zusammengefasst sind.

5. Solares Zentralreceiversystem nach Anspruch 1 und 4, **dadurch gekennzeichnet, dass** im Nahfeld das Heliostatenfeld unterhalb des Receivers die Abstände benachbarter Gruppen von Heliostaten (2383) innerhalb jedes Moduls (2380) jeweils einen vorgegebenen ersten Abstand und der Abstand benachbarter Modulreihen (2181, 2381) in der dazu senkrechten Richtung einen vorgegebenen zweiten Abstand zueinander aufweisen.

6. Solares Zentralreceiversystem nach Anspruch 1 und einem der Ansprüche 2 bis 5, **dadurch gekennzeichnet, dass** die erste Drehachse der Gruppe von Heliostaten (1283, 1383) mechanisch derart gekoppelt ist, dass die Heliostaten (1290, 1390) eine gemeinsamen Drehachse (1292, 1392) haben.

7. Solares Zentralreceiversystem nach Anspruch 1 und einem der Ansprüche 2 bis 6, **dadurch gekennzeichnet, dass** die Tragestruktur für den Receiver sich als ein Bogen über das Heliostatenfeld erstreckt, wobei zwei oder mehrere Fußpunkte des Bogens sich bevorzugt im Außenbereich oder außerhalb des Heliostatenfeldes befinden.

8. Solares Zentralreceiversystem nach Anspruch 1 und einem der Ansprüche 2 bis 6, **dadurch gekennzeichnet, dass** die Tragestruktur für den Receiver sich als ein Sprengwerk, d.h. als ein dreieckförmiges Tragwerk, über das Heliostatenfeld erstreckt, wobei zwei oder mehrere Fußpunkte des Sprengwerkes sich bevorzugt im Außenbereich oder außerhalb des Heliostatenfeldes befinden.

9. Solares Zentralreceiversystem nach Anspruch 1 und einem der Ansprüche 2 bis 6, **dadurch gekennzeichnet, dass** die Tragestruktur für den Receiver sich als eine abgehängte Seilkonstruktion über das Heliostatenfeld erstreckt, wobei zwei oder mehrere Fußpunkte der abgehängten Seilkonstruktion sich bevorzugt im Außenbereich oder außerhalb des Heliostatenfeldes befinden.

10. Solares Zentralreceiversystem nach Anspruch 1 und einem der Ansprüche 2 bis 6, **dadurch gekennzeichnet, dass** die Tragestruktur für den Receiver sich als ein kranförmiges Tragwerk mit einem den Receiver tragenden Ausleger oder Kragarm über das Heliostatenfeld erstreckt, wobei ein oder mehrere Fußpunkte des kranförmigen Tragwerks sich entweder im Außenbereich oder bevorzugt außerhalb des Heliostatenfeldes auf der vom Äquator abgewandten Seite des Receivers befinden.

11. polares Zentralreceiversystem nach Anspruch 1 und 10, **dadurch gekennzeichnet, dass** der Ausleger (2622, 2722) der kranförmigen Tragstruktur um die vertikale Achse drehbar ist, wodurch die Position des Receivers (2610, 2710) verändert werden kann, dass vorzugsweise der Receiver entlang des Auslegers (2622, 2722) der kranförmigen Tragstruktur verschiebbar angeordnet ist, wodurch die Position des Receivers (2610, 2710) zusätzlich verändert werden kann, und dass vorzugsweise die Höhe des Receivers (2610, 2710) veränderbar angeordnet ist.

12. Solares Zentralreceiversystem nach Anspruch 1 und einem der Ansprüche 2 bis 11, **dadurch gekennzeichnet, dass** die Tragestruktur auf ihrer dem Heliostatenfeld zugewandten Unterseite den Receiver in einer hängenden Anordnung trägt.

13. Solares Zentralreceiversystem nach Anspruch 1 und einem der Ansprüche 2 bis 12, **dadurch gekennzeichnet, dass** das Heliostatenfeld sich in Nord-, Ost-, Süd- und West-Richtung unterhalb und um den Receiver herum erstreckt, wobei ein kontinuierlich durchgehendes Heliostatenfeld gebildet wird.

14. Solares Zentralreceiversystem nach Anspruch 1 und einem der Ansprüche 2 oder 3 bzw. einem der Ansprüche 6 bis 13, **dadurch gekennzeichnet, dass** das Heliostatenfeld zusätzlich zum Nahfeld ein Fernfeld (1638) aufweist, in dem die Abstände zwischen den Heliostaten in Ost-West-Richtung bzw. Nord-Süd-Richtung mit zunehmenden Abstand vom Receiver zunehmen.

15. Solares Zentralreceiversystem nach Anspruch 1 und einem der Ansprüche 4 bis 13, **dadurch gekennzeichnet, dass** das Heliostatenfeld zusätzlich zum Nahfeld ein Fernfeld (2238) aufweist, in dem mit zunehmenden Abstand vom Receiver die Abstände zwischen den Modulreihen (2481) in Nord-Süd-Richtung zunehmen bzw. in Ost-West-Richtung die Abstände zwischen Gruppen von Heliostaten (2483) innerhalb eines Modules (2480) von einem Modul zum nächsten zunehmen.

16. Solares Zentralreceiversystem nach Anspruch 1 und einem der Ansprüche 2 bis 15, **dadurch gekennzeichnet, dass** die Receiverhöhe $H_R$ mindestens 100 m und dass der größte Durchmesser $D_H$ des Heliostatenfeldes bevorzugt weniger als das Sechsfache der Receiverhöhe $H_R$ beträgt.

17. Verfahren zur Erstellung eines Heliostatenfeldes eines solaren Zentralreceiversystems nach einem der Ansprüche 1 - 16, bestehend aus folgenden Schritten:

a) wobei im ersten Schritt eine Aufstellung der Heliostaten (1790; 1290, 1390) für ein Nahfeld (1636; 2236) auf einer vorzugsweise ebenen Gesamtgrundfläche definiert wird, das eine Reflektorflächendichte p von p > 60% aufweist,

b) wobei die gemeinsame Aufstellfläche einer oder mehrerer Gruppen von Heliostaten (1283; 1383) zur Gesamtgrundfläche jeweils um einen von der Position zum Receiver abhängigen Winkel $\alpha$ geneigt sein kann,

• wobei im zweiten Schritt die Positionen der Heliostaten mit dem Abstand vom Receiver (1610; 2210) bestimmt werden, woraus sich ergibt, wie weit das Nahfeld (1636; 2236) mit gleicher Reflektorflächendichte p um den Receiver herum reicht und
• wo das Fernfeld (1638; 2238)anschließend an das Nahfeld beginnt,
• wobei im Fernfeld die Abstände in Ost-West-Richtung bzw. Nord-Süd-Richtung derart groß sind, damit das gegenseitige Blockieren der Heliostaten weitgehend vermieden bzw. gering gehalten wird,
• wobei Blockieren bedeutet, dass ein Heliostat den Strahlengang vom Reflektor eines benachbarten Heliostaten zur Zielfläche des Receivers mindestens teilweise abdeckt,

c) wobei im dritten Schritt diejenigen Heliostaten für das Heliostatenfeld verwendet werden, die zum Auslegungszeitpunkt oder anderen bestimmten Zeitpunkten oder Zeiträumen den höchsten Beitrag zur Strahlungsleistung auf der Zielfläche des Receivers leisten,

• wobei das Heliostatenfeld mindestens aus einem Nahfeld und, je nach erforderlicher Strahlungsleistung auf der Zielfläche des Receivers, auch aus einem Fernfeld besteht,
• wobei, sofern die Receiverhöhe $H_R$ mindestens 100 m beträgt, ein Fernfeld vorhanden ist und der größte Durchmesser $D_H$ des Heliostatenfeldes verzugsweise weniger als das Sechsfache der Receiverhöhe $H_R$ beträgt,
• wobei im vierten Schritt eine Tragstruktur vorhanden ist, die geeignet ist, den Receiver (1410) in der definierten Position über dem Heliostatenfeld zu halten, wobei diese Tragstruktur ausgebildet ist als

i. ein Bogen,
ii. oder ein Sprengwerk
iii. oder eine abgehängte Seilkonstruktion,

• wobei diese drei Tragstrukturen, i, ii und iii, mit jeweils mindestens zwei Fußpunkten, die sich bevorzugt im Außenbereich oder außerhalb des Heliostatenfeldes befinden,

iv. oder ein kranförmiges Tragwerk mit einem den Receiver (1410) tragenden Ausleger bzw. Kragarm(1422), der sich über das Heliostatenfeld erstreckt,

• wobei ein oder mehrere Fußpunkte des kranförmigen Tragwerks sich entweder im Außenbereich oder bevorzugt außerhalb des Heliostatenfeldes auf der vom Äquator abgewandten Seite des Receivers befinden,
• wobei die Position eines am Ausleger (2622, 2722) montierten Receivers (2610, 2710) in bis zu drei Dimensionen veränderbar sein kann,
• so dass für das im dritten Schritt bestimmte Heliostatenfeld verschiedene Positionen für den Receiver für bestimmte Sonnenstände vorgesehen sind, um den Wirkungsgrad des Heliostatenfeldes für die jeweiligen Sonnenstände zu erhöhen.

**Claims**

1. Central receiver solar system with a heliostat field, consisting of

a) one or more receivers (110),
b) a plurality of heliostats (190), forming the heliostat field (130), which are arranged on a preferably level overall ground surface, wherein each heliostat has a reflector (795; 995) that can be moved about two rotary axles (792, 793; 992, 993), which reflects the solar radiation onto the target surface of the one or more receivers during changing position of the sun, wherein the target surface is configured as an aperture (1511; 2011) or a thermal absorber (2015) or a photovoltaic absorber (2015) of the respective receiver,
wherein each heliostat has a first rotary axle and a second rotary axle perpendicular to the first rotary axle and is arranged on a mounting surface,
wherein the first rotary axle (792; 992) is rigidly arranged relative to the mounting surface and the second rotary axle (793; 993) relative to the reflector (795; 995), and
c) a support structure (120), on which the one or more receivers (110) are secured above the heliostat field (130),
d) the heliostat field is formed with parallel rows of heliostats,
e) the first rotary axle (992; 1292, 1392) for each heliostat is oriented parallel to the mounting surface
f) heliostats with a common mounting surface are arranged in a row, so that the first rotary axle (1292, 1392; 1792) of the heliostats in the respective group lie on the same line, i.e., are aligned with each other,
g) each reflector (995; 1295, 1395; 1795) is rectangular in configuration,
**characterized in that**,
h) the support structure for the receiver is configured as a support structure reaching across the heliostat field,
i) the normal vector of the target surface of the receiver is pointed downward, preferably perpendicular, at the heliostat field
j) the heliostat field has a near field (1636; 2236) underneath the receiver, which as a reflector surface density $\rho$ of $\rho > 60\%$, where the reflector surface density $\rho$ is defined as the ratio of the the overall reflector surface of a region of the heliostat field to the built-over ground surface of the same region of the heliostat field, and the reflector is preferably longer in the direction of the second rotary axle (993; 1293, 1393) than in the direction perpendicular to this.

2. Central receiver solar system according to claim 1, **characterized in that** in the near field (1636; 2236) the spacings of neighboring heliostats within each row have a predetermined first spacing and the spacings of neighboring rows have a predetermined second spacing from each other in the direction perpendicular to this.

3. Central receiver solar system according to claim 1 or 2, **characterized in that** the rows of the heliostat field are oriented in the east-west direction or the rows of the heliostat field are oriented in the north-south direction.

4. Central receiver solar system according to claim 1, **characterized in that** the common mounting surface of one or more groups ofheliostats (1283; 1383) is inclined to the overall ground surface each time by an angle $\alpha$, dependent on the position to the receiver, while a number of groups of heliostats with common mounting surface and with parallel first rotary axles in a row perpendicular to the first rotary axle are assembled into a module (1280, 2180, 2380, 2480) and several modules are assembled into a module row (2181, 2381; 2481).

5. Central receiver solar system according to claim 1 and 4, **characterized in that** in the near field, the heliostat field underneath the receiver, the spacings of neighboring groups ofheliostats (2383) within each module (2380) each time have a predetermined first spacing and the spacing of neighboring module rows (2181, 2381) in the direction perpendicular to this have a predetermined second spacing from each other.

6. Central receiver solar system according to claim 1 and one of claims 2 to 5, **characterized in that** the first rotary axle of the group ofheliostats (1283, 1383) is mechanically coupled so that the heliostats (1290, 1390) have a common rotary axle.

7. Central receiver solar system according to claim 1 and one of claims 2 to 6, **characterized in that** the support structure for the receiver extends as an arch across the heliostat field, wherein two or more footpoints of the arch are preferably located in the outer region or outside the heliostat field.

8. Central receiver solar system according to claim 1 and one of claims 2 to 6, **characterized in that** the support structure for the receiver extends as a truss, i.e., a triangular frame, across the heliostat field, wherein two or more footpoints of the truss are preferably located in the outer region or outside of the heliostat field.

9. Central receiver solar system according to claim 1 and one of claims 2 to 6, **characterized in that** the support structure for the receiver extends as a suspended cable construction across the heliostat field, wherein two or more footpoints of the suspended cable construction are located preferably in the outer region or outside of the heliostat field.

10. Central receiver solar system according to claim 1 and one of claims 2 to 6, **characterized in that** the support structure for the receiver extends across the heliostat field as a cranelike support system with a jib or cantilever arm supporting the receiver, wherein one or more footpoints of the cranelike support system are located either in the outer region or preferably outside of the heliostat field on the side of the receiver facing away from the equator.

11. Central receiver solar system according to claims 1 and 10, **characterized in that** the jib (2622, 2722) of the cranelike support structure can turn about the vertical axis, so that the positions of the receiver (2610, 2710) can be changed, the receiver is preferably arranged able to move along the jib (2622, 2722) of the cranelike support structure, so that the position of the receiver (2610, 2710) can be additionally changed, and preferably the height of the receiver (2610, 2710) is arranged to be changeable.

12. Central receiver solar system according to claim 1 and one of claims 2 to 11, **characterized in that** the support structure carries the receiver in a suspended arrangement on its bottom side facing the heliostat field.

13. Central receiver solar system according to claim 1 and one of claims 2 to 12, **characterized in that** the heliostat field extends in the north, east, south and west direction underneath and around the receiver, forming a continuous heliostat field throughout.

14. Central receiver solar system according to claim 1 and one of claims 2 or 3 or one of claims 6 to 13, **characterized in that** the heliostat field in addition to the near field has a far field (1638), in which the spacings between the heliostats increase in the east-west direction or north-south direction with increasing distance from the receiver.

15. Central receiver solar system according to claim 1 and one of claims 4 to 13, **characterized in that** the heliostat field in addition to the near field has a far field (2238), in which with increasing distance from the receiver the spacings between the module rows (2481) increase in the north-south direction or in the east-west direction the spacings between groups of heliostats (2483) within a module (2480) increase from one module to the next.

16. Central receiver solar system according to claim 1 and one of claims 2 to 15, **characterized in that** receiver height $H_R$ is at least 100 and the largest diameter $D_H$ of the heliostat field is preferably less than six times the receiver height $H_R$.

17. Method for the design of a heliostat field of a central receiver solar system according to one of claims 1 to 16, consisting of the following steps:

    a) wherein, in the first step, a setup of heliostats (1790; 1290, 1390) is defined for a near field (1636; 2236) on a preferably level overall ground surface, having a reflector surface density $\rho$ of $\rho > 60\%$,

b) wherein the common mounting surface of one or more groups of heliostats (1283; 1383) can be inclined to the overall ground surface by an angle α dependent on the position to the receiver,

• wherein in the second step the positions of the heliostats are determined with the distance from the receiver (1610; 2210), calculating how far the near field (1636; 2236) with the same reflector surface density ρ reaches around the receiver and
• where the far field (1638; 2238) then begins at the near field,
• wherein in the far field the distances in the east-west direction and north-south direction must be increased to prevent or reduce the mutual blocking of the heliostats as much as possible,
• wherein blocking means that a heliostat at least partly covers the beam path from the reflector of an adjacent heliostat to the target surface of the receiver,

c) wherein in the third step the radiation power which the respective heliostats transfer onto the target surface of the receiver (1610; 2210) is calculated and preferably those heliostats are chosen for the heliostat field that contribute at the designed time or other determined times the highest component to the radiation power on the target surface of the receiver,

• wherein the heliostat field is formed at least by a near field and, depending on the required radiation power on the target surface of the receiver, also a far field,
• wherein, if a receiver height $H_R$ of at least 100 m is chosen, a far field is provided and the largest diameter $D_H$ of the heliostat field is preferably less than six times the receiver height $H_R$,
• wherein in the fourth step a support structure is chosen, which is suitable to holding the receiver (1410) in the defined position above the heliostat field, this support structure being configured as

i. an arch,
ii. or a truss,
iii. or a suspended cable construction,

• wherein these three support structures i, ii and iii, each with at least two footpoints that are preferably located in the outer region or outside the heliostat field,

iv. or a cranelike support system with a jib or cantilever arm (1422) supporting the receiver (1410), which extends across the heliostat field,

• wherein one or more footpoints of the cranelike support system is located either in the outer region or preferably outside of the heliostat field on the side of the receiver facing away from the equator,
• wherein the position of a receiver (2610, 2710) mounted on the jib (2622, 2722) can be changed in up to three dimensions,
• so that for the heliostat field determined in the third step different positions can be chosen for the receiver for particular positions of the sun in order to increase the efficiency of the heliostat field for the respective positions of the sun.

**Revendications**

1. Centrale solaire à récepteur central avec un champ d'héliostats, composée de

a) un ou plusieurs récepteurs (110),
b) une pluralité d'héliostats (190) formant le champ d'héliostats (130), arrangés sur une surface de terre plate de préférence, où chaque héliostat a un réflecteur (795; 995) pouvant être déplacé autour de deux axes rotatifs (792, 793; 992, 993) et reflétant le rayonnement solaire sur la surface cible d'un ou de plusieurs récepteurs pendant la position changeante du soleil, où la surface cible est configurée comme ouverture (1511; 2011) ou un absorbeur thermique (2015) ou un absorbeur photovoltaïque (2015) du récepteur respectif,
Où chaque héliostat présente un premier axe rotatif et un deuxième axe rotatif perpendiculaire au premier axe rotatif et est arrangé sur une surface de montage,
Où le premier axe rotatif (792; 992) est arrangé de manière rigide relativement à la surface de montage et le deuxième axe rotatif (793; 993) relativement au réflecteur (795 ; 995), et

c) une structure portante (120), sur laquelle un ou plusieurs récepteurs (110) sont fixés au-dessus du champ d'héliostats (130),

d) le champ d'héliostats est formé avec des rangées parallèles d'héliostats,

e) le premier axe rotatif (992; 1292, 1392) de chaque héliostat est orienté de manière parallèle à la surface de montage,

f) des héliostats ayant une surface de montage commune sont mis en rangée, de façon à ce que le premier axe rotatif (1292, 1392; 1792) des héliostats dans le groupe respectif se trouvent sur la même ligne, donc sont alignés les uns avec les autres,

g) chaque réflecteur (995; 1295, 1395; 1795) est rectangulaire en configuration,

**caractérisé par le fait que**

h) la structure portante pour le récepteur est configurée comme structure portante à travers le champ d'héliostats,

i) le vecteur normal de la surface cible du récepteur est dirigé vers le bas, de préférence de manière perpendiculaire, sur le champ d'héliostats,

j) le champ d'héliostats a un champ proche (1636; 2236) en-dessous du récepteur, ayant une densité superficielle de réflecteur p de p > 60%, où la densité superficielle de réflecteur p est définie comme étant le ratio de la surface de réflecteur totale d'une région du champ d'héliostats par rapport à la surface de terre par-dessus de laquelle il est construit de la même région du champ d'héliostats, le réflecteur étant de préférence plus long dans la direction du deuxième axe rotatif (993; 1293, 1393) que dans sa direction perpendiculaire.

2. Centrale solaire à récepteur central selon la revendication 1, **caractérisée par le fait que** dans le champ proche (1636; 2236), les espacements des héliostats voisins au sein de chaque rangée ont un premier espacement prédéterminé et les espacements des rangées voisines ont un deuxième espacement prédéterminé les unes des autres dans la direction qui leur est perpendiculaire.

3. Centrale solaire à récepteur central selon les revendications 1 ou 2, **caractérisée par le fait que** les rangées du champ d'héliostats sont orientées dans la direction est-ouest ou les rangées du champ d'héliostats sont orientées dans la direction nord-sud.

4. Centrale solaire à récepteur central selon la revendication 1, **caractérisée par le fait que** la surface de montage commune d'un ou de plusieurs groupes d'héliostats (1283; 1383) est inclinée à la surface de terre totale chaque fois par un angle $\alpha$, en fonction de la position par rapport au récepteur, alors que certains groupes d'héliostats ayant une surface de montage commune et des premiers axes rotatifs parallèles dans une rangée perpendiculaire au premier axe rotatif, sont assemblés dans un module (1280, 2180, 2380, 2480) et plusieurs modules sont assemblés dans une rangée de modules (2181, 2381; 2481).

5. Centrale solaire à récepteur central selon les revendications 1 et 4, **caractérisée par le fait que** dans le champ proche, le champ d'héliostats en-dessous du récepteur, les espacements des groupes voisins d'héliostats (2383) au sein de chaque module (2380) chaque fois ont un premier espacement prédéterminé et l'espacement des rangées de modules voisines (2181, 2381) dans la direction qui leur est perpendiculaire ont un second espacement prédéterminé les uns des autres.

6. Centrale solaire à récepteur central selon la revendication 1 et une des revendications 2 à 5, **caractérisée par le fait que** le premier axe rotatif du groupe d'héliostats (1283, 1383) est couplé mécaniquement de façon à ce que les héliostats (1290, 1390) aient un axe rotatif commun (1292, 1392).

7. Centrale solaire à récepteur central selon la revendication 1 et une des revendications 2 à 6, **caractérisée par le fait que** la structure portante pour le récepteur s'étend comme une arche à travers le champ d'héliostats, où deux pointes de pieds ou plus de l'arche sont de préférence situées dans la région extérieure ou en dehors du champ d'héliostats.

8. Centrale solaire à récepteur central selon la revendication 1 et une des revendications 2 à 6, **caractérisée par le fait que** la structure portante pour le récepteur s'étend comme une arche à travers le champ d'héliostats, où deux pointes de pieds ou plus de l'arche sont de préférence situées dans la région extérieure ou en dehors du champ d'héliostats.

9. Centrale solaire à récepteur central selon la revendication 1 et une des revendications 2 à 6, **caractérisée par le fait que** la structure portante pour le récepteur s'étend comme une construction suspendue de câbles à travers le champ d'héliostats, où deux pointes de pieds ou plus de la construction suspendue de câbles sont de préférence situées dans la région extérieure ou en dehors du champ d'héliostats.

10. Centrale solaire à récepteur central selon la revendication 1 et une des revendications 2 à 6, **caractérisée par le fait que** la structure portante pour le récepteur s'étend à travers le champ d'héliostats comme une structure portante de type grue, avec un foc ou un bras cantilever portant le récepteur, où une ou deux pointes de pieds ou plus de la structure portante de type grue sont situées soit dans la région extérieure soit de préférence en dehors du champ d'héliostats, du côté du récepteur dans l'autre sens de l'équateur.

11. Centrale solaire à récepteur central selon les revendications 1 et 10, **caractérisée par le fait que** le foc (2622, 2722) de la structure portante de type grue peut tourner autour de l'axe vertical, de sorte que les positions du récepteur (2610, 2710) peuvent être changées, le récepteur est de préférence arrangé de manière à pouvoir bouger tout au long du foc (2622, 2722) de la structure portante de type grue, de façon à ce que la position du récepteur (2610, 2710) puisse être également changée, et de préférence la hauteur du récepteur (2610, 2710) est arrangée de façon à être changeable.

12. Centrale solaire à récepteur central selon la revendication 1 et une des revendications 2 à 11, **caractérisée par le fait que** la structure portante porte le récepteur dans un arrangement suspendu sur sa face inférieure faisant face au champ d'héliostats.

13. Centrale solaire à récepteur central selon la revendication 1 et une des revendications 2 à 12, **caractérisée par le fait que** le champ d'héliostats s'étend dans la direction du nord, est, sud et ouest en-dessous et autour du récepteur, formant un champ d'héliostats continu partout.

14. Centrale solaire à récepteur central selon la revendication 1 et une des revendications 2 ou 3 ou une des revendications 6 à 13, **caractérisée par le fait que** le champ d'héliostats en plus du champ proche a un champ lointain (1638), où les espacements entre les héliostats augment dans la direction est-ouest ou la direction nord-sud avec distance croissante du récepteur.

15. Centrale solaire à récepteur central selon la revendication 1 et une des revendications 4 à 13, **caractérisée par le fait que** le champ d'héliostats en plus du champ proche a un champ lointain (2238), où avec une distance croissante du récepteur, les espacements entre les rangées de modules (2481) augmentent dans la direction nord-sud ou dans la direction est-ouest les espacements entre les groupes d'héliostats (2483) au sein d'un module (2480) augmentent d'un module à l'autre.

16. Centrale solaire à récepteur central selon la revendication 1 et une des revendications 2 à 15, **caractérisée par le fait que** la hauteur du récepteur $H_R$ est au moins 100 et le diamètre le plus large $D_H$ du champ d'héliostats fait de préférence moins de six fois la hauteur $H_R$ du récepteur.

17. Méthode pour la conception d'un champ d'héliostats d'une centrale solaire à récepteur central selon une des revendications 1 à 16, comprenant les étapes suivantes:

a) dans la première étape, une installation d'héliostats (1790; 1290, 1390) est définie pour un champ proche (1636; 2236) sur une surface de terre plate de préférence, ayant une densité superficielle de réflecteur p de p > 60%,

b) la surface de montage commune d'un ou de plusieurs groupes d'héliostats (1283; 1383) peut être inclinée à la surface de terre totale par un angle α en fonction de la position du récepteur,

• les positions des héliostats étant déterminées dans la deuxième étape avec la distance du récepteur (1610; 2210), calculant quelle distance le champ proche (1636; 2236) avec la même densité superficielle de réflecteur p atteint-il autour du récepteur et
• le champ lointain (1638; 2238) commençant alors au champ proche,
• dans le champ lointain les distances dans la direction est-ouest et la direction nord-sud devant être augmentées pour prévenir ou réduire dans la mesure du possible le blocage mutuel des héliostats,
• le blocage signifiant qu'un héliostat couvre au moins en partie le chemin du faisceau du réflecteur d'un héliostat adjacent à la surface cible du récepteur.

c) dans la troisième étape, la puissance de rayonnement que les héliostats respectifs transfèrent à la surface cible du récepteur (1610; 2210) est calculée, et de préférence ces héliostats sont choisis du champ d'héliostats qui fournissent au temps désigné ou à d'autre temps désignés le composant le plus élevé a la puissance de rayonnement sur la surface cible du récepteur,

• le champ d'héliostats étant formé au moins par un champ proche et, en fonction de la puissance de rayonnement requise sur la surface cible du récepteur, également d'un champ lointain,
• si une hauteur de récepteur $H_R$ d'au moins 100 m est choisie, un champ lointain étant fourni et le diamètre le plus grand $D_H$ du champ d'héliostats étant de préférence moins que six fois la hauteur du récepteur $H_R$,
• dans la quatrième étape, une structure portante étant choisie, ce qui est convenable pour porter le récepteur (1410) dans la position définie au-dessus du champ d'héliostats, cette structure portante étant configurée comme

i. une arche,
ii. ou un treillis,
iii. ou une construction suspendue de câbles,

• chacune de ces trois structures portantes i, ii et iii ayant au moins deux pointes de pieds se trouvant de préférence dans la région extérieure ou hors du champ d'héliostats,

iv. ou une structure portante de type grue ayant un foc ou un bras cantilever (1422) portant le récepteur (1410), qui s'étend à travers le champ d'héliostats,

• une ou plusieurs pointes de pieds de la structure portante de type grue se trouvant soit dans la région extérieure ou de préférence en dehors du champ d'héliostats du côté opposé à l'équateur du récepteur,
• la position d'un récepteur (2610, 2710) monté sur le foc (2622, 2722) pouvant être changée jusqu'à dans trois dimensions,
• de sorte que pour le champ d'héliostats déterminé dans la troisième étape différentes positions du récepteur peuvent être choisies pour des positions particulières du soleil afin d'augmenter l'efficacité du champ d'héliostats pour les positions respectives du soleil.

Fig. 1:

Fig. 2:

Fig. 3:

Fig. 4

Fig. 5:

Fig. 6:

Fig. 7:

Fig. 8:

Fig. 9:

Fig. 10:

Fig. 11:

Fig. 12:

Fig. 13:

Fig. 14:

Fig. 15:

Fig. 16:

Fig. 17:

$$A_{OW}(n) \; < \; A_{OW}(n+1)$$

$A_{NS}(m+1)$

$>$

$A_{NS}(m)$

N

1890

1890

Fig. 18:

······· Abstände Heliostaten N-S Richtung   — —   Abstände Heliostaten O-W Richtung

Abstand der Heliostaten [m]

Abstand vom Receiver [m], Negative Werte: Süden oder Osten

Fig. 19:

2015 & 2011

2015 & 2011

2015 & 2011

$B_{R\_NS}$

$n_R$   $B_{R\_OW}$

a)          b)

Fig. 20:

Fig. 21:

Fig. 22:

Fig. 23:

Fig. 24:

Fig. 25:

Fig. 26:

Fig. 27:

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 4172443 A
- EP 2000669 A2
- US 4220140 A
- WO 2008154521 A1
- WO 02070966 A1
- WO 2008092194 A1
- WO 2008092195 A1
- WO 2008153922 A1

### In der Beschreibung aufgeführte Nicht-Patentliteratur

- **WINTER, C.-J. ; SIZMANN, R. L. ; VANT-HULL, L. L.** Solar Power Plants. Springer, 1991
- **BURGALET, J-I ; ARIAS, S ; SALBIDEGOITIA I.B.** Operative advantage of a central tower solar plant with thermal storage system. *SolarPACES 2009, Conference Proceedings,* 01. September 2009, ISBN 978-3-00-028755-8
- **GOULD, B.** Molten Salt Power Towers. *Presentation at DOE Program Review,* 23. April 2008
- **KOLL, G. ; SCHWARZBÖZL, P. ; HENNECKE, K. ; HARTZ, T. ; SCHMITZ, M. ; HOFFSCHMIDT, B.** The solar tower Jülich - A research and demonstration plant for central Receiver systems. *SolarPACES 2009 Conference Proceedings,* 2009, ISBN 978-3-00-028755-8
- **ABENGOA SOLAR S.A.** White Paper on Solar Tower Technologies. *Solutions to Global Climate Change,* 19. August 2010
- **STEVE SCHELL.** Design and evaluation of eSolar's Heliostat field. *SolarPACES 2009 Conference Proceedings,* 01. September 2009, ISBN 978-3-00-028755-8
- **SCHRAMEK, P. ; MILLS, D.R.** Heliostat for maximum ground coverage. *Energy,* 2004, vol. 29, 701-713
- **BUCK, R. ; BRÄUNING, T. ; DENK, T. ; PFÄNDER, M. ; SCHWARZBÖZL, P. ; TÉLLEZ, F.** Solar-Hybrid Gas Turbine-based Power Tower Systems (REFOS). *Journal of Solar Energy Engineering,* Februar 2002, vol. 124, 2-9
- Datenblatt Turmdrehkran 132 EC-H8 FR.tronic. **LIEBHERR.** 132 EC-H8 Litronic. Liebherr-Werk Biberach GmbH